# EUROPEAN PATENT APPLICATION

(11) **EP 4 517 831 A1**
(43) Date of publication of application: **05.03.2025**
(21) Application number: 24186950.2
(22) Date of filing: 05.07.2024
(51) Int. Cl.: H01L 29/423, H10B 12/00, H01L 29/786, H10B 41/70, H10B 43/30, H01L 27/06, H01L 27/105, H01L 29/788, H01L 29/792

(54) **SEMICONDUCTOR MEMORY DEVICE AND METHOD FOR FABRICATING THE SAME**

(30) Priority: 31.08.2023 KR 20230115246
(71) Applicant: Samsung Electronics Co., Ltd, Suwon-si, Gyeonggi-do 16677 (KR)
(72) Inventor: KIM, Jun Soo, 16677 Suwon-si (KR); JANG, Sung Ho, 16677 Suwon-si (KR)
(74) Representative: Marks & Clerk LLP

(57) **Abstract**

A capacitor-less semiconductor memory device and a method for fabricating the same are provided. The semiconductor memory device includes a first metal-oxide semiconductor film (142), a second metal-oxide semiconductor film (144) spaced apart from the first metal-oxide semiconductor film (142), a first gate electrode (182) intersecting the first metal-oxide semiconductor film (142) and the second metal-oxide semiconductor film (144), a first gate dielectric film (132) interposed between the first metal-oxide semiconductor film (142) and the first gate electrode (182), a charge storage film (150) in the first gate dielectric film, the charge storage film (150) extending along at least a portion of the first metal-oxide semiconductor film (142) and connected to the second metal-oxide semiconductor film (144), a second gate electrode (184) spaced apart from the first gate electrode (182) and intersecting the second metal-oxide semiconductor film (144), and a second gate dielectric film (134) interposed between the second metal-oxide semiconductor film (144) and the second gate electrode (184).

## Description

### BACKGROUND

### 1. Technical Field

The present disclosure relates to a semiconductor memory device and a method for fabricating the same, and more particularly, to a capacitor-less semiconductor memory device and a method for fabricating the same.

### 2. Description of the Related Art

Semiconductor memory devices may be classified into volatile memory devices such as Static RAM (SRSM), Dynamic RAM (DRAM), Synchronous DRAM (SDRAM), etc., whose stored data is lost when the power supply is cut off; and non-volatile memory devices such as Read Only Memory (ROM), Programmable ROM (PROM), Electrically Programmable ROM (EPROM), Electrically Erasable and Programmable ROM (EEPROM), Flash memory device, Phase-change RAM (PRAM), Magnetic RAM (MRAM), Resistive RAM (RRAM), Ferroelectric RAM (FRAM), etc., whose stored data is retained even when the power supply is cut off.

Recently, channel layers containing metal-oxide semiconductor materials have been studied to improve the performance of the semiconductor memory devices. The metal-oxide semiconductor materials have excellent leakage current characteristics by having an on-current similar to that of silicon (Si) and a high band gap energy.

### SUMMARY

Aspects of the present disclosure provide a semiconductor memory device that may have improved performance and integration.

Aspects of the present disclosure also provide a method for fabricating a semiconductor memory device that may be capable of improved performance and integration.

However, aspects of the present disclosure are not restricted to those set forth herein. The above and other aspects of the present disclosure will become more apparent to one of ordinary skill in the art to which the present disclosure pertains by referencing the detailed description of the present disclosure given below.

According to aspects of the present inventive concept, there is provided a semiconductor memory device comprising a first metal-oxide semiconductor film, a second metal-oxide semiconductor film spaced apart from the first metal-oxide semiconductor film, a first gate electrode intersecting the first metal-oxide semiconductor film and the second metal-oxide semiconductor film, a first gate dielectric film interposed between the first metal-oxide semiconductor film and the first gate electrode, a charge storage film in the first gate dielectric film, the charge storage film extending along at least a portion of the first metal-oxide semiconductor film and connected to the second metal-oxide semiconductor film, a second gate electrode spaced apart from the first gate electrode and intersecting the second metal-oxide semiconductor film, and a second gate dielectric film interposed between the second metal-oxide semiconductor film and the second gate electrode.

According to aspects of the present inventive concept, there is provided a semiconductor memory device comprising a substrate, a circuit element on the substrate, a lower insulating film on the substrate, the lower insulating film covering the circuit element, a first wiring structure on the lower insulating film, the first wiring structure including a first wiring pattern and a second wiring pattern spaced apart from each other, a first metal-oxide semiconductor film on the first wiring structure, the first metal-oxide semiconductor film connected to the first wiring pattern and the second wiring pattern, a second metal-oxide semiconductor film on the first wiring structure, the second metal-oxide semiconductor film spaced apart from the first metal-oxide semiconductor film, a first gate electrode intersecting the first metal-oxide semiconductor film and the second metal-oxide semiconductor film, a charge storage film between the first metal-oxide semiconductor film and the first gate electrode, the charge storage film connected to the second metal-oxide semiconductor film, a second gate electrode intersecting the second metal-oxide semiconductor film and not intersecting the first metal-oxide semiconductor film, a second wiring structure on the first gate electrode and the second gate electrode, the second wiring structure including a third wiring pattern connected to the second metal-oxide semiconductor film, and a third wiring structure on the second wiring structure, the third wiring structure including a fourth wiring pattern connected to the first gate electrode and a fifth wiring pattern connected to the second gate electrode.

According to aspects of the present inventive concept, there is provided a semiconductor memory device comprising a substrate, a circuit element on the substrate, a lower insulating film on the substrate, the lower insulating film covering the circuit element, a first wiring structure on the lower insulating film, the first wiring structure including a first wiring pattern and a connection pattern spaced apart from each other, a first gate electrode on the first wiring structure, the first gate electrode spaced apart from the first wiring structure, a second gate electrode on the first gate electrode, the second gate electrode spaced apart from the first gate electrode, a first metal-oxide semiconductor film intersecting the first gate electrode and connected to the first wiring pattern, a charge storage film between the first gate electrode and the first metal-oxide semiconductor film, the charge storage film connected to the connection pattern, a second metal-oxide semiconductor film intersecting the first gate electrode and the second gate electrode, and connected to the connection pattern, a second wiring structure on the first metal-oxide semiconductor film and the second metal-oxide semiconductor film, the second wiring structure including a second wiring pattern connected to the first metal-oxide semiconductor film and a third wiring pattern connected to the second metal-oxide semiconductor film, and a third wiring structure on the second wiring structure, the third wiring structure including a fourth wiring pattern connected to the first gate electrode and a fifth wiring pattern connected to the second gate electrode.

At least some of the above and other features of the invention are set out in the claims.

### BRIEF DESCRIPTION OF THE DRAWINGS

The above and other aspects and features of the present disclosure will become more apparent by describing in detail embodiments thereof with reference to the attached drawings, in which:
FIG. 1 is a circuit diagram illustrating a unit memory cell of a semiconductor memory device according to some embodiments.
FIG. 2 is a cross-sectional view illustrating a semiconductor memory device according to some embodiments.
FIGS. 3 and 4 are various partial perspective views illustrating the semiconductor memory device of FIG. 2.
FIGS. 5 to 7 are various cross-sectional views illustrating a semiconductor memory device according to some embodiments.
FIG. 8 is a cross-sectional view illustrating a semiconductor memory device according to some embodiments.
FIGS. 9 and 10 are various partial perspective views illustrating the semiconductor memory device of FIG. 8.
FIGS. 11 to 13 are various cross-section views illustrating a semiconductor memory device according to some embodiments.
FIG. 14 is a cross-sectional view illustrating a semiconductor memory device according to some embodiments.
FIG. 15 is an partial perspective view illustrating the semiconductor memory device of FIG. 14.
FIGS. 16 to 29 are intermediate step views illustrating a method for fabricating a semiconductor memory device according to some embodiments.
FIGS. 30 to 36 are intermediate step views illustrating a method for fabricating a semiconductor memory device according to some embodiments.
FIGS. 37 to 43 are intermediate step views illustrating a method for fabricating a semiconductor memory device according to some embodiments.

### DETAILED DESCRIPTION OF THE EMBODIMENTS

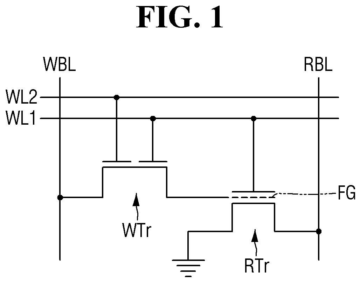

Hereinafter, a semiconductor memory device according to embodiments will be described with reference to FIGS. 1 to 15. Although the figures described herein may be referred to using language such as "one embodiment," or "certain embodiments," these figures, and their corresponding descriptions are not intended to be mutually exclusive from other figures or descriptions, unless the context so indicates. Therefore, certain aspects from certain figures may be the same as certain features in other figures, and/or certain figures may be different representations or different portions of a particular embodiment. Items described in the singular herein may be provided in plural, as can be seen, for example, in the drawings. Thus, the description of a single item that is provided in plural should be understood to be applicable to the remaining plurality of items unless context indicates otherwise.

Spatially relative terms, such as "beneath," "below," "lower," "above," "upper," "top," "bottom," "front," "rear," and the like, may be used herein for ease of description to describe positional relationships, such as illustrated in the figures, for example. It will be understood that the spatially relative terms encompass different orientations of the device in addition to the orientation depicted in the figures. The term "cover" and other forms of the word "cover" include partial covering.

FIG. 1 is a circuit diagram illustrating a unit memory cell of a semiconductor memory device according to some embodiments.

Referring to FIG. 1, a unit memory cell of a semiconductor memory device according to some embodiments includes a first transistor RTr, a second transistor WTr, a pair of bit lines RBL and WBL, and a pair of word lines WL1 and WL2. In the following description, ordinal numbers such as "first," "second," "third," etc. may be used simply as labels of certain elements, steps, etc., to distinguish such elements, steps, etc. from one another. Terms that are not described using "first," "second," etc., in the specification, may still be referred to as "first" or "second" in a claim. In addition, a term that is referenced with a particular ordinal number (e.g., "first" in a particular claim) may be described elsewhere with a different ordinal number (e.g., "second" in the specification or another claim).

Each of the first transistor RTr and the second transistor WTr may include a field effect transistor (FET) including a channel and a gate. In addition, the first transistor RTr may further include a floating gate FG interposed between the channel and the gate of the first transistor RTr. In the semiconductor memory device according to some embodiments, the first transistor RTr of the unit memory cell may be provided as a read transistor, and the second transistor WTr of the unit memory cell may serve as a write transistor. For example, the unit memory cell of the semiconductor memory device according to some embodiments may store data (e.g., 0 or 1) in the floating gate FG of the first transistor RTr. A drain of the second transistor WTr is connected to the floating gate FG of the first transistor RTr so that data may be written to the floating gate FG.

In the following description it will be understood that when an element is referred to as being "connected" to another element, including other forms of the word "connect", the element can be electrically connected and/or physically connected to the other element. Furthermore, intervening elements may be present unless the element is described as directly connected to the other element. When an element is referred to as being "directly connected" to another element, or as "contacting" or "in contact with" another element (or using any form of the word "contact"), there are no intervening elements present at the point of contact.

As used herein, items that are "electrically connected" are configured such that an electrical signal can be passed from one item to the other. Therefore, conductive elements that are physically, directly connected to one another are electrically connected. Furthermore, a passive electrically conductive component (e.g., a wire, pad, internal electrical line, etc.) physically connected to a passive electrically insulative component (e.g., a prepreg layer of a printed circuit board, an electrically insulative adhesive connecting two devices, an electrically insulative underfill or mold layer, etc.) is not electrically connected to that component. Moreover, items that are "directly electrically connected," to each other are electrically connected through one or more passive elements, such as, for example, wires, pads, internal electrical lines, through vias, etc. As such, directly electrically connected components do not include components electrically connected through active elements, such as transistors or diodes. Directly electrically connected elements may be directly physically connected and directly electrically connected.

The pair of word lines WL1 and WL2 may include a first word line WL1 and a second word line WL2 forming one row. The first word line WL1 may be connected to both the gate of the first transistor RTr and the gate of the second transistor WTr. The second word line WL2 may be connected to the gate of the second transistor WTr and may be not connected to the gate of the first transistor RTr.

The first transistor RTr and the second transistor WTr may be connected between a pair of bit lines RBL and WBL that are complementary to each other. The pair of bit lines RBL and WBL may include a first bit line RBL and a second bit line WBL forming one column. The first bit line RBL may be connected to a drain of the first transistor RTr, and the second bit line WBL may be connected to a source of the second transistor WTr.

The first bit line RBL may be provided as a read bit line to read data of a selected unit memory cell during a read operation. The second bit line WBL may be provided as a write bit line to write data to a selected unit memory cell during a read operation. For example, the first bit line RBL and the second bit line WBL may be connected to a sense amplifier having a latch function. The sense amplifier may detect and amplify signals transmitted from the first bit line RBL and the second bit line WBL.

In some embodiments, the sense amplifier may include a voltage sense amplifier. For example, the sense amplifier may read the data (e.g., 0 or 1) stored in the first transistor RTr by detecting a voltage difference between the first bit line RBL and the second bit line WBL.

Table 1 below illustrates an operation of the semiconductor memory device according to some embodiments.

**[Table 1]**

| | WL1 | WL2 | WBL | RBL |
|---|---|---|---|---|
| WO | H | H | 0 | - |
| W1 | H | H | L | - |
| R | H | 0 | - | H |

As an example, during a write operation WO for writing low-level data (e.g., 0) to the unit memory cell, a high-level voltage H may be applied to both the first word line WL1 and the second word line WL2, and a ground voltage (0) may be applied to the second bit line WBL. Through this, the second transistor WTr may be turned on, and charges may be stored in the floating gate FG through the second bit line WBL.

As an example, during a write operation W1 for writing high-level data (e.g., 1) to the unit memory cell, a high-level voltage H may be applied to both the first word line WL1 and the second word line WL2, and a low-level voltage L may be applied to the second bit line WBL. Through this, the second transistor WTr may be turned on, and charges may be emitted from the floating gate FG through the second bit line WBL.

For example, during a read operation R for reading the data stored in a unit memory cell, a high-level voltage H may be applied to the first word line WL1, a ground voltage (0) may be applied to the second word line WL2, and a high-level voltage H may be applied to the first bit line RBL. Through this, the second transistor WTr may be turned off. In addition, since a threshold voltage of the first transistor RTr may vary depending on the charges stored in the floating gate FG, the data (e.g., 0 or 1) stored in the floating gate FG may be read through the first bit line RBL.

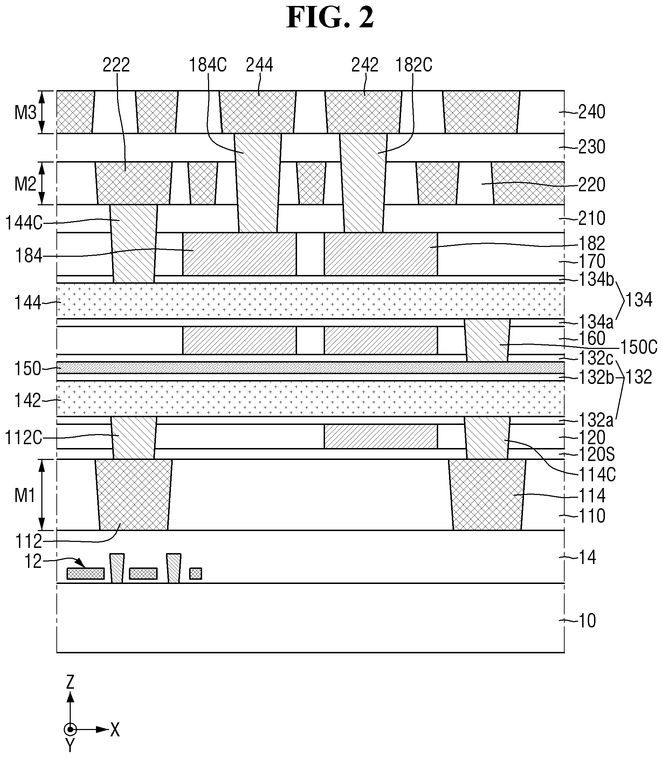

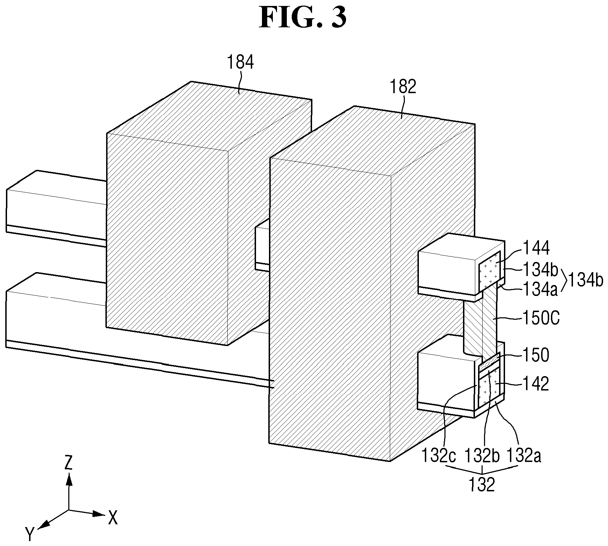

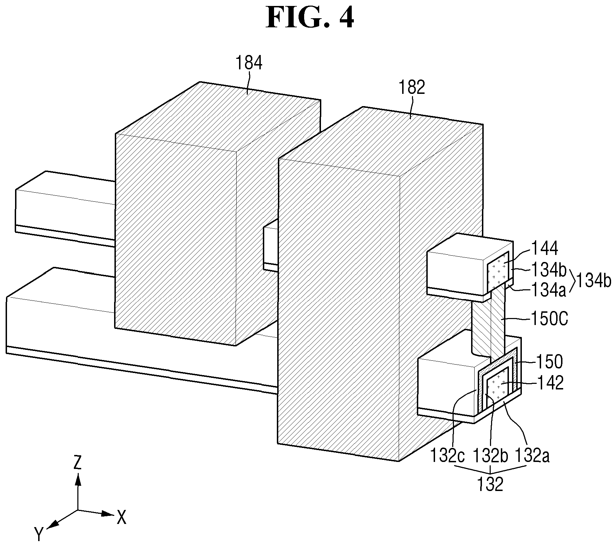

FIG. 2 is a cross-sectional view illustrating a semiconductor memory device according to some embodiments. FIGS. 3 and 4 are various partial perspective views illustrating the semiconductor memory device of FIG. 2 with various components removed for clarity. The cross-section of FIG. 2 corresponds to a vertical plane (e.g., the XZ plane) along the center of the partial perspective view.

Referring to FIGS. 1 to 4, the semiconductor memory device according to some embodiments may include a substrate 10, a circuit element 12, a first wiring structure M1, a first gate dielectric film 132, a second gate dielectric film 134, a first metal-oxide semiconductor film 142, a second metal-oxide semiconductor film 144, a charge storage film 150, a first gate electrode 182, a second gate electrode 184, a second wiring structure M2, and a third wiring structure M3.

The substrate 10 may be bulk silicon or silicon-on-insulator (SOI). The substrate 10 may also be a silicon substrate, or may be formed of and/or include other materials, for example, silicon germanium, gallium arsenide, silicon germanium on insulator (SGOI), indium antimonide, lead telluride, indium arsenide, indium phosphide, or gallium antimonide. Alternatively, the substrate 10 may be a substrate in which an epitaxial layer is formed on a base substrate, or may be a ceramic substrate, a quartz substrate, or a glass substrate for a display.

The circuit element 12 may be formed on the substrate 10. The circuit element 12 may include, for example, a transistor, but is not limited thereto. For example, the circuit element 12 may include various active elements such as transistors, as well as various passive elements such as capacitors, resistors, and inductors. It will be understood that when an element is referred to as being "formed on" another element, it can be directly formed on the other element or intervening elements may be present. In contrast, when an element is referred to as being "directly formed on" or "contacting" another element, there are no intervening elements present at the point of contact.

In some embodiments, the circuit element 12 may include control elements that are formed on substrate 10 and control a function of the semiconductor memory device. For example, the circuit element 12 may include a column decoder, a row decoder, a sense amplifier SA, a sub wordline driver SWL, etc.

The first wiring structure M1 may be formed on the circuit element 12. For example, a lower insulating film 14 covering the circuit element 12 may be formed on the substrate 10. The first wiring structure M1 may be stacked on the lower insulating film 14. The lower insulating film 14 may be formed of and/or include, but is not limited to, for example, at least one of silicon oxide, silicon oxynitride, and a low-k material having a dielectric constant lower than that of silicon oxide.

The first wiring structure M1 may include a first inter-wiring insulating film 110 and a first wiring pattern 112 and a second wiring pattern 114 spaced apart from each other within the first inter-wiring insulating film 110. The first wiring pattern 112 and the second wiring pattern 114 may be insulated from each other by the first inter-wiring insulating film 110. In some embodiments, the first wiring pattern 112 and the second wiring pattern 114 may provide a ground line (or Vss) of FIG. 1 and the first bit line RBL of FIG. 1. As an example, the first wiring pattern 112 may be provided as the ground line (or Vss) of FIG. 1, and the second wiring pattern 114 may be provided as the first bit line RBL of FIG. 1. As another example, the first wiring pattern 112 may be provided as the first bit line RBL of FIG. 1, and the second wiring pattern 114 may be provided as the ground line (or Vss) of FIG. 1.

The first metal-oxide semiconductor film 142 may be formed on the first wiring structure M1. For example, a first etch stop film 120S and a first interlayer insulating film 120 may be sequentially formed on the first wiring structure M1. The first metal-oxide semiconductor film 142 may be formed on the first interlayer insulating film 120. In some embodiments, the first metal-oxide semiconductor film 142 may extend along a plane (e.g., XY plane) parallel to an upper surface of the substrate 10. As an example, the first metal-oxide semiconductor film 142 may extend to be long in a first direction X.

It is illustrated in FIGS. 3 and 4 that a cross-section of the first metal-oxide semiconductor film 142 intersecting and/or normal to the first direction X has a quadrangular shape, but this is only an example and other embodiments are not limited to using this shape. The cross-section of the first metal-oxide semiconductor film 142 intersecting and/or normal to the first direction X may also have other shapes such as a polygonal or circular shape.

The first metal-oxide semiconductor film 142 may be formed of and/or include a metal-oxide semiconductor material. The metal-oxide semiconductor material may include, but is not limited to, for example, indium gallium zinc oxide (IGZO, InₓGa_{y}Zn_{z}O), indium gallium silicon oxide (IGSO, InₓGa_{y}Si_{z}O), indium tin zinc oxide (ITZO, InₓSn_{y}Zn_{z}O), indium zinc oxide (IZO, InₓZn_{y}O), zinc oxide (ZnO, ZnₓO), zinc tin oxide (ZTO, ZnₓSn_{y}O), zinc oxynitride (ZnON, ZnₓO_{y}N), zirconium zinc tin oxide (ZZTO, ZrₓZn_{y}Sn_{z}O), tin oxide (SnO, SnₓO), hafnium indium zinc oxide (HIZO, HfₓIn_{y}Zn_{z}O), gallium zinc tin oxide (GZTO, GaₓZn_{y}Sn_{z}O), aluminum zinc tin oxide (AZTO, AlₓZn_{y}Sn_{z}O), ytterbium gallium zinc oxide (YGZO, YbₓGa_{y}Zn_{z}O), indium gallium oxide (IGO, InₓGa_{y}O), or a combination thereof. As an example, the first metal-oxide semiconductor film 142 may include an IGZO film.

The first gate dielectric film 132 may be formed on the first metal-oxide semiconductor film 142. The first gate dielectric film 132 may cover at least a portion of a surface of the first metal-oxide semiconductor film 142. For example, the first gate dielectric film 132 may extend along a perimeter of the first metal-oxide semiconductor film 142 (e.g., an external surface appearing as the perimeter when viewed in a cross-section such FIGS. 2, 3, and 4).

The first gate dielectric film 132 may be formed of and/or include a dielectric material, for example, silicon oxide, silicon oxynitride, a high-k material having a dielectric constant greater than that of silicon oxide, or a combination thereof. The high-k material may include, but is not limited to, for example, at least one of hafnium oxide (HfO₂), hafnium silicon oxide (HfSiO), hafnium silicon oxynitride (HfSiON), hafnium tantalum oxide (HfTaO), hafnium titanium oxide (Hf IiO), hafnium zirconium oxide (HfZrO), zirconium oxide (ZrO₂), aluminum oxide (Al₂O₃), or a combination thereof.

In some embodiments, the first gate dielectric film 132 may include a first sub-dielectric film 132a, a second sub-dielectric film 132b, and a third sub-dielectric film 132c.

The first sub-dielectric film 132a may cover a lower surface of the first metal-oxide semiconductor film 142. For example, the first sub-dielectric film 132a may conformally extend along an upper surface of the first interlayer insulating film 120, and the first metal-oxide semiconductor film 142 may be formed on an upper surface of the first sub-dielectric film 132a and extend in the first direction X.

The second sub-dielectric film 132b may cover the upper surface of the first metal-oxide semiconductor film 142. For example, the second sub-dielectric film 132b may be formed on the first sub-dielectric film 132a and the first metal-oxide semiconductor film 142. The second sub-dielectric film 132b may conformally extend along the upper surface of the first metal-oxide semiconductor film 142. In FIG. 3, it is illustrated that the second sub-dielectric film 132b exposes a side surface of the first metal-oxide semiconductor film 142, but this is only an example, and in other examples such as FIG. 4, the second sub-dielectric film 132b may also cover the side surface of the first metal-oxide semiconductor film 142.

The third sub-dielectric film 132c may cover the second sub-dielectric film 132b. For example, the third sub-dielectric film 132c may be formed on the first sub-dielectric film 132a and the second sub-dielectric film 132b. The third sub-dielectric film 132c may conformally extend along the side surface of the first metal-oxide semiconductor film 142 and a side surface and an upper surface of the second sub-dielectric film 132b.

The first sub-dielectric film 132a, the second sub-dielectric film 132b, and the third sub-dielectric film 132c may be formed of and/or include the same dielectric material as one another or may be formed of and/or include different dielectric materials. It is illustrated in FIGS. 3 and 4 that a boundary exists between the first sub-dielectric film 132a, the second sub-dielectric film 132b, and the third sub-dielectric film 132c, but this is only an example, and in other examples, a boundary does not exist between the first sub-dielectric film 132a, the second sub-dielectric film 132b, and the third sub-dielectric film 132c. For example, the first sub-dielectric film 132a, second sub-dielectric film 132b, and/or third sub-dielectric film 132c may be formed using the same process as one another.

In some embodiments, the first metal-oxide semiconductor film 142 may be connected to the first wiring pattern 112 and the second wiring pattern 114. For example, a first contact 112C penetrating through the first etch stop film 120S, the first interlayer insulating film 120, and the first sub-dielectric film 132a and connected to the first wiring pattern 112 and to the first metal-oxide semiconductor film 142 may be formed. In addition, for example, a second contact 114C penetrating through the first etch stop film 120S, the first interlayer insulating film 120, and the first sub-dielectric film 132a and connected to the second wiring pattern 114 and the first metal-oxide semiconductor film 142 may be formed. The first metal-oxide semiconductor film 142 may be provided as a channel of the first transistor RTr of FIG. 1.

The charge storage film 150 is formed within the first gate dielectric film 132. The charge storage film 150 may be spaced apart from the first metal-oxide semiconductor film 142 by the first gate dielectric film 132. For example, the charge storage film 150 may be interposed between the second sub-dielectric film 132b and the third sub-dielectric film 132c. That is, the first metal-oxide semiconductor film 142 and the charge storage film 150 may be separated from each other in at least one portion by the second sub-dielectric film 132b therebetween.

The charge storage film 150 may be formed of and/or include, but is not limited to, a material capable of storing charges, for example, at least one of polysilicon (poly Si) or silicon nitride (SiN). As an example, the charge storage film 150 may be formed of and/or include a polysilicon film. The charge storage film 150 may be provided as the floating gate FG of the first transistor RTr of FIG. 1.

In some embodiments, as illustrated in FIG. 3, the charge storage film 150 may be formed on the upper surface of the first metal-oxide semiconductor film 142 and may be not formed on the side surface of the first metal-oxide semiconductor film 142. For example, the second sub-dielectric film 132b may cover the upper surface of the first metal-oxide semiconductor film 142 and expose the side surface of the first metal-oxide semiconductor film 142. The charge storage film 150 may cover the upper surface of the second sub-dielectric film 132b and expose the side surface of the second sub-dielectric film 132b and the side surface of the first metal-oxide semiconductor film 142. The third sub-dielectric film 132c may cover an upper surface of the charge storage film 150, the side surface of the second sub-dielectric film 132b, and the side surface of the first metal-oxide semiconductor film 142.

In some embodiments, as illustrated in FIG. 4, the charge storage film 150 may be formed on the upper and side surfaces of the first metal-oxide semiconductor film 142. For example, the second sub-dielectric film 132b may cover the upper and side surfaces of the first metal-oxide semiconductor film 142. The charge storage film 150 may cover the upper and side surfaces of the second sub-dielectric film 132b. The third sub-dielectric film 132c may cover the upper and side surfaces of the charge storage film 150.

The second metal-oxide semiconductor film 144 may be formed on the first wiring structure M1. The second metal-oxide semiconductor film 144 is spaced apart from first metal-oxide semiconductor film 142. In some embodiments, the first metal-oxide semiconductor film 142 and the second metal-oxide semiconductor film 144 may be arranged along a second direction Z that intersects and/or is normal to the upper surface of the substrate 10. For example, the second interlayer insulating film 160 may be formed on the first gate dielectric film 132. The second metal-oxide semiconductor film 144 may be formed on the second interlayer insulating film 160. In some embodiments, the second metal-oxide semiconductor film 144 may extend parallel to the first metal-oxide semiconductor film 142. For example, the second metal-oxide semiconductor film 144 may extend to be long in the first direction X.

It is illustrated in FIGS. 3 and 4 that a cross-section of the second metal-oxide semiconductor film 144 intersecting and/or is normal to the first direction X has a quadrangular shape, but this is only an example. In other embodiments, the cross-section of the second metal-oxide semiconductor film 144 intersecting and/or normal to the first direction X may have a different shape such as a polygonal or circular shape.

The second metal-oxide semiconductor film 144 may be formed of and/or include a metal-oxide semiconductor material. The second metal-oxide semiconductor film 144 may include the same metal-oxide semiconductor material as the first metal-oxide semiconductor film 142, or may include a metal-oxide semiconductor material different from that of the first metal-oxide semiconductor film 142. As an example, the second metal-oxide semiconductor film 144 may include an IGZO film.

The second gate dielectric film 134 may be formed on the second metal-oxide semiconductor film 144. The second gate dielectric film 134 may cover at least a portion of a surface of the second metal-oxide semiconductor film 144. For example, the second gate dielectric film 134 may extend along a perimeter of the second metal-oxide semiconductor film 144 (e.g., an external surface appearing as the perimeter when viewed in a cross-section such FIGS. 2, 3, and 4). The second gate dielectric film 134 may be formed of and/or include the same dielectric material as the first gate dielectric film 132, or may be formed of and/or include a dielectric material different from that of the first gate dielectric film 132.

In some embodiments, the second gate dielectric film 134 may include a fourth sub-dielectric film 134a and a fifth sub-dielectric film 134b.

The fourth sub-dielectric film 134a may cover at least a portion of a lower surface of the second metal-oxide semiconductor film 144. For example, the fourth sub-dielectric film 134a may conformally extend along an upper surface of the second interlayer insulating film 160, and the second metal-oxide semiconductor film 144 may be formed on an upper surface of the fourth sub-dielectric film 134a and extend in the first direction X.

The fifth sub-dielectric film 134b may cover the side and upper surfaces of the second metal-oxide semiconductor film 144. For example, the fifth sub-dielectric film 134b may be formed on the fourth sub-dielectric film 134a and the second metal-oxide semiconductor film 144. The fifth sub-dielectric film 134b may conformally extend along the side and upper surfaces of the second metal-oxide semiconductor film 144.

The fourth sub-dielectric film 134a and the fifth sub-dielectric film 134b may be formed of and/or include the same dielectric material as one another or different dielectric materials. It is illustrated in FIGS. 3 and 4 that a boundary exists between the fourth sub-dielectric film 134a and the fifth sub-dielectric film 134b, but this is only an example, and in some cases, the boundary may not exist between the fourth sub-dielectric film 134a and the fifth sub-dielectric film 134b. For example, the first sub-dielectric film 132a, second sub-dielectric film 132b, and/or third sub-dielectric film 132c may be formed during the same process.

The second metal-oxide semiconductor film 144 is connected to the charge storage film 150. For example, a third contact 150C penetrating through the third sub-dielectric film 132c, the second interlayer insulating film 160, and the fourth sub-dielectric film 134a and connected to the charge storage film 150 and to the second metal-oxide semiconductor film 144 may be formed. The second metal-oxide semiconductor film 144 may be provided as a channel of the second transistor WTr of FIG. 2.

The first gate electrode 182 may be formed on the first gate dielectric film 132 and the second gate dielectric film 134. The first gate electrode 182 intersects the first metal-oxide semiconductor film 142 and the second metal-oxide semiconductor film 144. An element "intersecting" another element may pass through the other element and may divide the other element. This will be more evident in the description of a method for fabricating the semiconductor memory device. For example, the third interlayer insulating film 170 may be formed on the second gate dielectric film 134. The first gate electrode 182 may extend in the second direction Z and penetrate through the first interlayer insulating film 120, the second interlayer insulating film 160, and the third interlayer insulating film 170. In some embodiments, the first gate electrode 182 may be in contact with an upper surface of the first etch stop film 120S. In some embodiments, the first gate electrode 182 may intersect the first metal-oxide semiconductor film 142 between the first contact 112C and the second contact 114C.

At least a portion of the first gate dielectric film 132 is interposed between the first metal-oxide semiconductor film 142 and the first gate electrode 182. The first metal-oxide semiconductor film 142 and the first gate electrode 182 may be separated from each other by the first gate dielectric film 132. A portion of the second gate dielectric film 134 is interposed between the second metal-oxide semiconductor film 144 and the first gate electrode 182. The second metal-oxide semiconductor film 144 and the first gate electrode 182 may be separated from each other by the second gate dielectric film 134.

At least a portion of the charge storage film 150 may be interposed between the first metal-oxide semiconductor film 142 and the first gate electrode 182. The charge storage film 150 may be spaced apart from the first gate electrode 182 by the first gate dielectric film 132. For example, the charge storage film 150 may be interposed between the second sub-dielectric film 132b and the third sub-dielectric film 132c. That is, the charge storage film 150 and the first gate electrode 182 may be separated from each other by the third sub-dielectric film 132c therebetween.

The second gate electrode 184 may be formed on the second gate dielectric film 134. The second gate electrode 184 is spaced apart from the first gate electrode 182. In some embodiments, the first gate electrode 182 and the second gate electrode 184 may be arranged along the first direction X. The second gate electrode 184 intersects the second metal-oxide semiconductor film 144, and in an embodiment does not intersect the first metal-oxide semiconductor film 142. For example, the second gate electrode 184 may extend in the second direction Z, and may penetrate through the second interlayer insulating film 160 and the third interlayer insulating film 170 and in an embodiment does not penetrate through the first interlayer insulating film 120.

Another portion of the second gate dielectric film 134 is interposed between the second metal-oxide semiconductor film 144 and the second gate electrode 184. The second metal-oxide semiconductor film 144 and the second gate electrode 184 may be separated from each other by the second gate dielectric film 134.

In some embodiments, the first metal-oxide semiconductor film 142 may extend in the first direction X, and may penetrate through the first gate electrode 182 and does not penetrate through the second gate electrode 184. That is, the first gate electrode 182 may surround at least a portion of the perimeter of the first metal-oxide semiconductor film 142.

In some embodiments, the second metal-oxide semiconductor film 144 may extend in the first direction X and may penetrate through the first gate electrode 182 and the second gate electrode 184. That is, the first gate electrode 182 may surround at least a portion of the perimeter of the first metal-oxide semiconductor film 142, and the second gate electrode 184 may surround another portion of the perimeter of the second metal-oxide semiconductor film 144.

The first gate electrode 182 and the second gate electrode 184 may each be formed of and/or include a conductive material, for example, at least one of, doped polysilicon, metal, conductive metal nitride, conductive metal silicide, conductive metal oxide, or a combination thereof. For example, the first gate electrode 182 may be formed of and/or include, but is not limited to, doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOₓ, RuOₓ, or a combination thereof. The first gate electrode 182 and the second gate electrode 184 may be formed of and/or include the same conductive material as one another or different conductive materials.

The second wiring structure M2 may be formed on the first gate electrode 182 and the second gate electrode 184. For example, a fourth interlayer insulating film 210 covering the first gate electrode 182, the second gate electrode 184, and the third interlayer insulating film 170 may be formed. The second wiring structure M2 may be formed on the fourth interlayer insulating film 210.

The second wiring structure M2 may include a second inter-wiring insulating film 220 and a third wiring pattern 222 within the second inter-wiring insulating film 220. In some embodiments, the third wiring pattern 222 may be connected to the second metal-oxide semiconductor film 144. For example, a fourth contact 144C penetrating through the fifth sub-dielectric film 134b, the third interlayer insulating film 170, and the fourth interlayer insulating film 210 and connected to the second metal-oxide semiconductor film 144 and to the third wiring pattern 222 may be formed. The third wiring pattern 222 may be provided as the second bit line WBL of FIG. 1. The first gate electrode 182 and the second gate electrode 184 may each intersect the second metal-oxide semiconductor film 144 between the third contact 150C and the fourth contact 144C.

The third wiring structure M3 may be formed on the second wiring structure M2. For example, a fifth interlayer insulating film 230 covering the second wiring structure M2 may be formed. The third wiring structure M3 may be formed on the fifth interlayer insulating film 230.

The third wiring structure M3 may include a third inter-wiring insulating film 240 and a fourth wiring pattern 242 and a fifth wiring pattern 244 spaced apart from each other within the third inter-wiring insulating film 240. In some embodiments, the fourth wiring pattern 242 may be connected to the first gate electrode 182, and the fifth wiring pattern 244 may be connected to the second gate electrode 184. For example, a fifth contact 182C penetrating through the fourth interlayer insulating film 210, the second inter-wiring insulating film 220, and the fifth interlayer insulating film 230 and connected to the first gate electrode 182 and to the fourth wiring pattern 242 may be formed. The fourth wiring pattern 242 may be provided as the first word line WL1 of FIG. 1. In addition, for example, a sixth contact 184C penetrating through the fourth interlayer insulating film 210, the second inter-wiring insulating film 220, and the fifth interlayer insulating film 230 and connected to the second gate electrode 184 and to the fifth wiring pattern 244 may be formed. The fifth wiring pattern 244 may be provided as the second word line WL2 of FIG. 1.

A capacitor-less semiconductor memory device that does not have a capacitor is being studied. For example, a capacitor-less semiconductor memory device has been proposed in which a drain of a write transistor is connected to a gate of a read transistor. However, a unit memory cell of such a capacitor-less semiconductor memory device has problems with random access by the write transistor and requires a current sense amplifier with a relatively large area.

Unlike the above mentioned capacitor-less semiconductor device, a unit memory cell of the semiconductor memory device according to some embodiments may be randomly accessed using the first word line WL1 and the second word line WL2. In addition, the semiconductor memory device according to some embodiments enables effective space design compared to the capacitor-less semiconductor memory device that requires the current sense amplifier, because of using the voltage sense amplifier through the first bit line RBL and the second bit line WBL. In addition, as described above, the semiconductor memory device according to some embodiments may be formed in a back end of line (BEOL) stage. Through this, a semiconductor device with improved performance and integration may be provided.

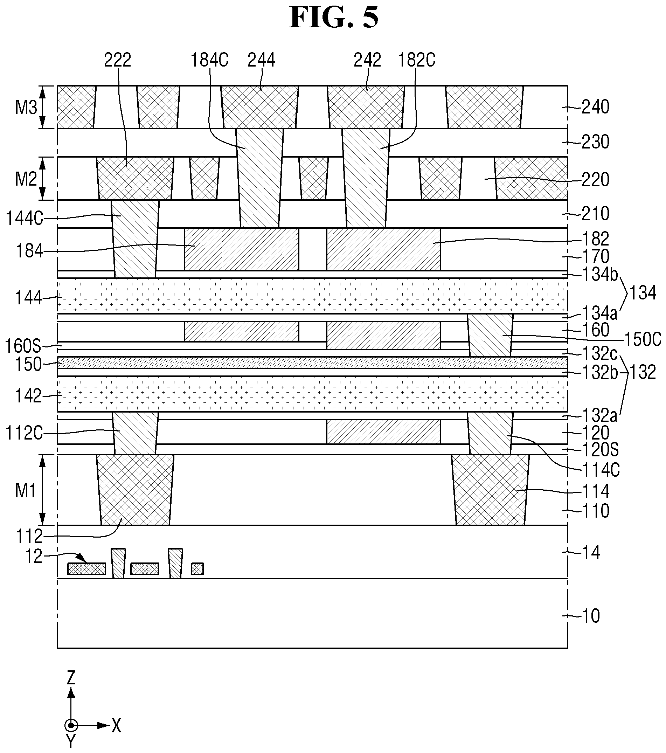

FIGS. 5 to 7 are various views illustrating a semiconductor memory device according to some embodiments. For convenience of explanation, portions of the description that may overlap with the description of FIGS. 1 to 4 may be briefly described or omitted.

Referring to FIG. 5, in the semiconductor memory device according to some embodiments, the second gate electrode 184 may be spaced apart from the first gate dielectric film 132.

For example, a second etch stop film 160S and a second interlayer insulating film 160 may be sequentially formed on the first gate dielectric film 132. The second gate electrode 184 may extend in the second direction Z to penetrate through the second interlayer insulating film 160 and the third interlayer insulating film 170, and may be in contact with an upper surface of the second etch stop film 160S. The second gate electrode 184 may be spaced apart from the first gate dielectric film 132 by the second etch stop film 160S.

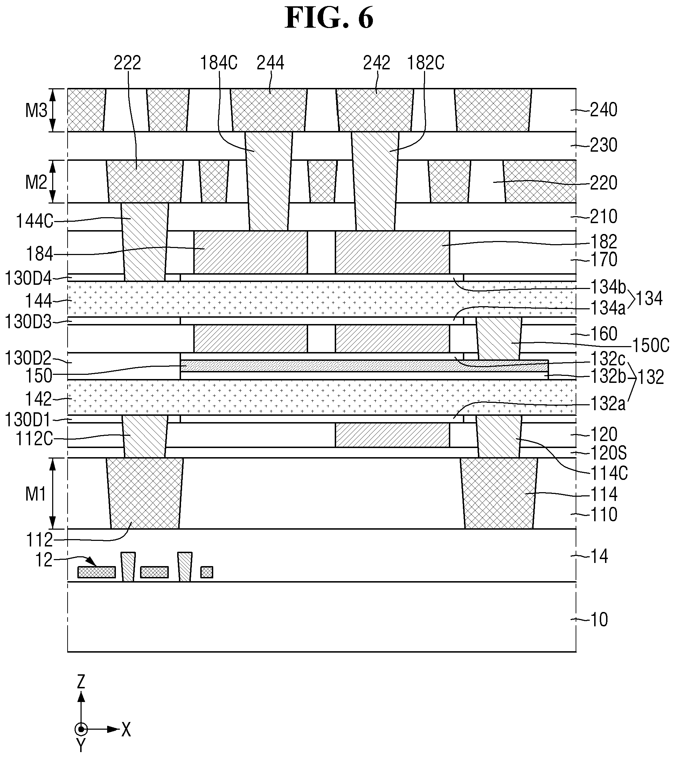

Referring to FIG. 6, the semiconductor memory device according to some embodiments may further include a first insertion insulating film 130D1, a second insertion insulating film 130D2, a third insertion insulating film 130D3, and a fourth insertion insulating film 130D4.

The first insertion insulating film 130D1 may be interposed between the first interlayer insulating film 120 and the first metal-oxide semiconductor film 142. The first sub-dielectric film 132a may be formed in the first insertion insulating film 130D1. In some embodiments, the first sub-dielectric film 132a may be interposed between the first contact 112C and the second contact 114C. The first contact 112C may penetrate through the first etch stop film 120S, the first interlayer insulating film 120, and the first insertion insulating film 130D1 and may be connected to the first wiring pattern 112 and to the first metal-oxide semiconductor film 142. The second contact 114C may penetrate through the first etch stop film 120S, the first interlayer insulating film 120, and the first insertion insulating film 130D1 and may be connected to the second wiring pattern 114 and the first metal-oxide semiconductor film 142.

The second insertion insulating film 130D2 may be interposed between the first metal-oxide semiconductor film 142 and the second interlayer insulating film 160. The second sub-dielectric film 132b, the charge storage film 150, and the third sub-dielectric film 132c may be formed in the second insertion insulating film 130D2. In some embodiments, the third sub-dielectric film 132c may expose a portion of the upper surface of the charge storage film 150. For example, a length at which the second sub-dielectric film 132b and the charge storage film 150 extend in the first direction X may be greater than a length at which the third sub-dielectric film 132c extends in the first direction X. The third contact 150C may be connected to a portion of the charge storage film 150 exposed from the third sub-dielectric film 132c.

The third insertion insulating film 130D3 may be interposed between the second interlayer insulating film 160 and the second metal-oxide semiconductor film 144. The fourth sub-dielectric film 134a may be formed in the third insertion insulating film 130D3. In some embodiments, the fourth sub-dielectric film 134a may be disposed between the third contact 150C and the fourth contact 144C in the first direction X. The third contact 150C may penetrate through the second insertion insulating film 130D2, the second interlayer insulating film 160, and the third insertion insulating film 130D3 and connect the charge storage film 150 to the second metal-oxide semiconductor film 144.

The fourth insertion insulating film 130D4 may be interposed between the second metal-oxide semiconductor film 144 and the third interlayer insulating film 170. The fifth sub-dielectric film 134b may be formed in the fourth insertion insulating film 130D4. In some embodiments, the fifth sub-dielectric film 134b may be disposed between the third contact 150C and the fourth contact 144C in the first direction X. The fourth contact 144C may penetrate through the fourth insertion insulating film 130D4, the third interlayer insulating film 170, and the fourth interlayer insulating film 210 and connect the second metal-oxide semiconductor film 144 to the third wiring pattern 222.

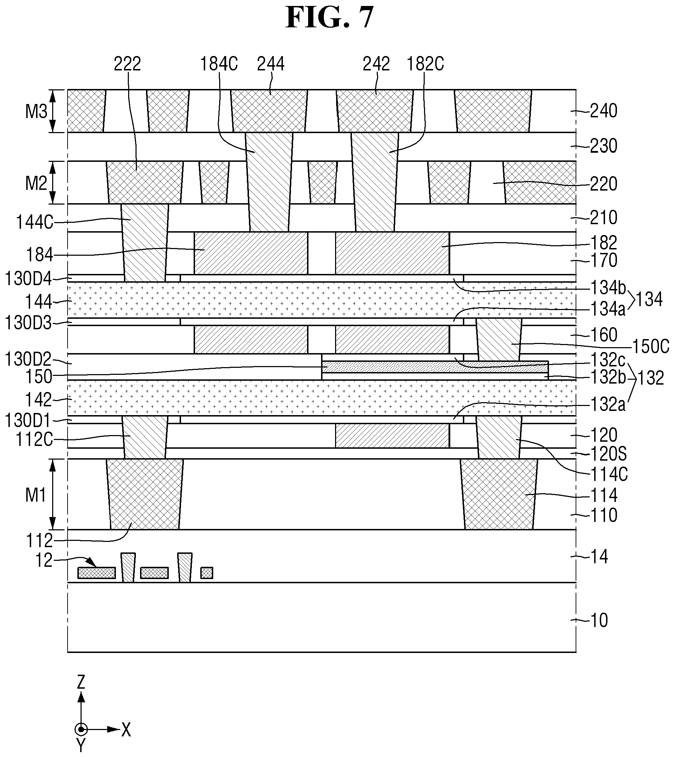

Referring to FIG. 7, in the semiconductor memory device according to some embodiments, the charge storage film 150 does not overlap the second gate electrode 184 in the second direction Z.

For example, the second insertion insulating film 130D2 may be formed between the first metal-oxide semiconductor film 142 and the second interlayer insulating film 160. The second insertion insulating film 130D2 may fill an area between the first metal-oxide semiconductor film 142 and the second gate electrode 184. The second sub-dielectric film 132b, the charge storage film 150, and the third sub-dielectric film 132c may be formed in the second insertion insulating film 130D2. The charge storage film 150 may extend in the first direction X between the first metal-oxide semiconductor film 142 and the first gate electrode 182 and between the first metal-oxide semiconductor film 142 and the third contact 150C, and may not extend between the first metal-oxide semiconductor film 142 and the second gate electrode 184.

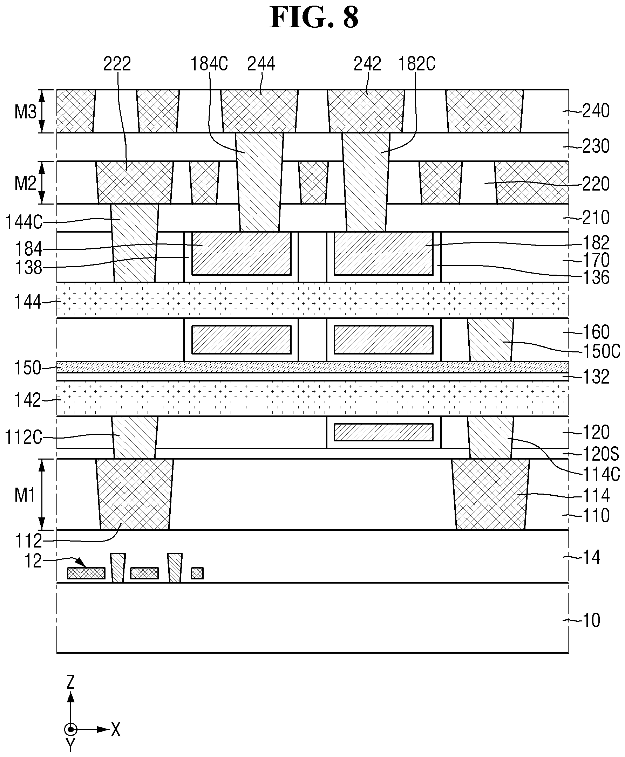

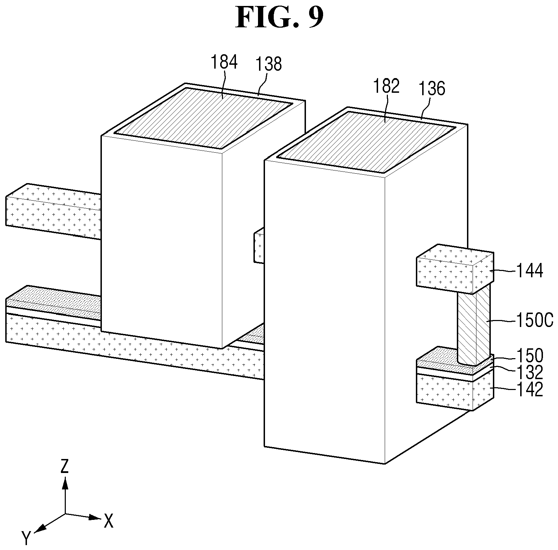

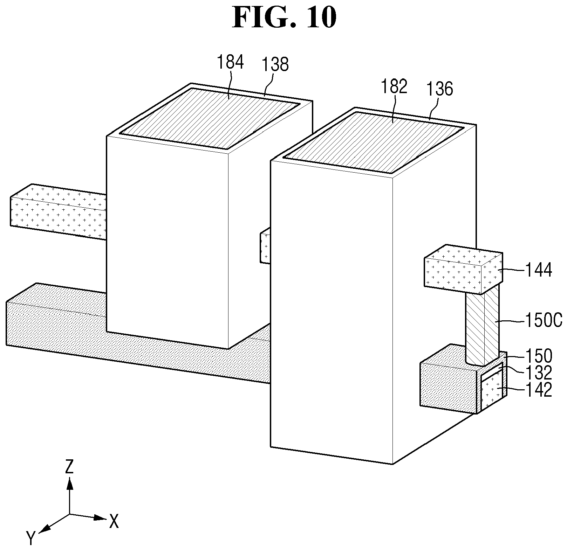

FIG. 8 is a cross-sectional view illustrating a semiconductor memory device according to some embodiments. FIGS. 9 and 10 are various partial perspective views illustrating the semiconductor memory device of FIG. 8. For convenience of explanation, portions of the description that may overlap with the description of FIGS. 1 to 4 may be briefly described or omitted.

Referring to FIGS. 8 to 10, the semiconductor memory device according to some embodiments may include the first gate dielectric film 132, the third gate dielectric film 136, and a fourth gate dielectric film 138.

The first gate dielectric film 132 may be formed between the first metal-oxide semiconductor film 142 and the charge storage film 150. For example, the first gate dielectric film 132 and the charge storage film 150 may be sequentially stacked on the first metal-oxide semiconductor film 142.

The third gate dielectric film 136 may be formed on the first metal-oxide semiconductor film 142 and the second metal-oxide semiconductor film 144. The third gate dielectric film 136 may be interposed between the first metal-oxide semiconductor film 142 and the first gate electrode 182 and between the second metal-oxide semiconductor film 144 and the first gate electrode 182. In addition, the third gate dielectric film 136 may further extend along an upper surface of the first etch stop film 120S, a side surface of the first interlayer insulating film 120, a side surface of the second interlayer insulating film 160, and a side surface of the third interlayer insulating film 170. In some embodiments, the charge storage film 150 may be interposed between the first gate dielectric film 132 and the third gate dielectric film 136.

The fourth gate dielectric film 138 may be formed on the second metal-oxide semiconductor film 144. The fourth gate dielectric film 138 may be interposed between the second metal-oxide semiconductor film 144 and the second gate electrode 184. In addition, the fourth gate dielectric film 138 may further extend along the side surface of the second interlayer insulating film 160 and the side surface of the third interlayer insulating film 170. In some embodiments, the fourth gate dielectric film 138 may further extend along the upper surface of the charge storage film 150.

The third gate dielectric film 136 and the fourth gate dielectric film 138 may each be formed of and/or include the same dielectric material as the first gate dielectric film 132, or may be formed of and/or include a dielectric material different from that of the first gate dielectric film 132.

In some embodiments, as illustrated in FIG. 9, the charge storage film 150 may be formed on the upper surface of the first metal-oxide semiconductor film 142, and may be not formed on the side surface of the first metal-oxide semiconductor film 142. For example, the second sub-dielectric film 132b may cover the upper surface of the first metal-oxide semiconductor film 142 and expose the side surface of the first metal-oxide semiconductor film 142. The charge storage film 150 may cover the upper surface of the second sub-dielectric film 132b and expose the side surface of the second sub-dielectric film 132b and the side surface of the first metal-oxide semiconductor film 142.

In some embodiments, as illustrated in FIG. 10, the charge storage film 150 may be formed on the upper and side surfaces of the first metal-oxide semiconductor film 142. For example, the second sub-dielectric film 132b may cover the upper and side surfaces of the first metal-oxide semiconductor film 142. The charge storage film 150 may cover the upper and side surfaces of the second sub-dielectric film 132b.

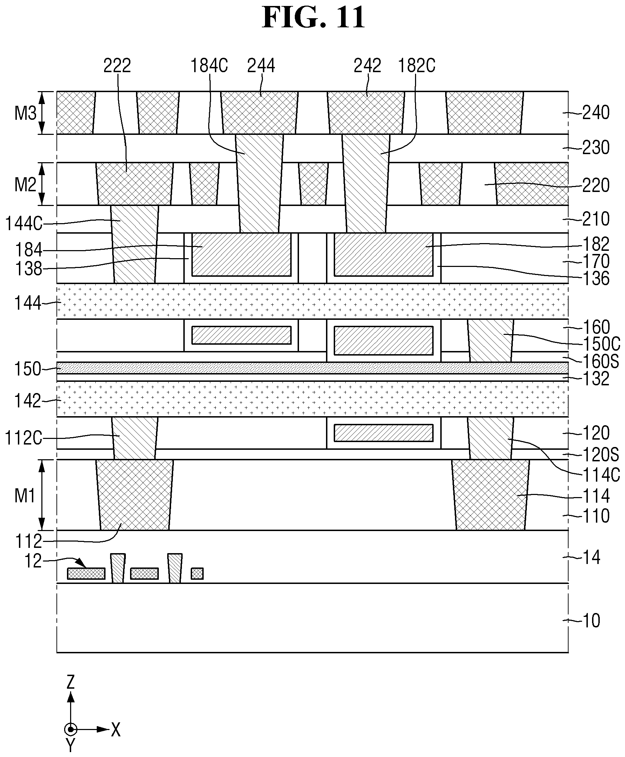

FIGS. 11 to 13 are various views illustrating a semiconductor memory device according to some embodiments. For convenience of explanation, portions of the description that may overlap with the description of FIGS. 1 to 10 may be briefly described or omitted.

Referring to FIG. 11, in the semiconductor memory device according to some embodiments, the fourth gate dielectric film 138 may be spaced apart from the charge storage film 150.

For example, the second etch stop film 160S and the second interlayer insulating film 160 may be sequentially formed on the charge storage film 150. The fourth gate dielectric film 138 may extend along the upper surface of the second etch stop film 160S. The fourth gate dielectric film 138 may be spaced apart from the charge storage film 150 by the second etch stop film 160S.

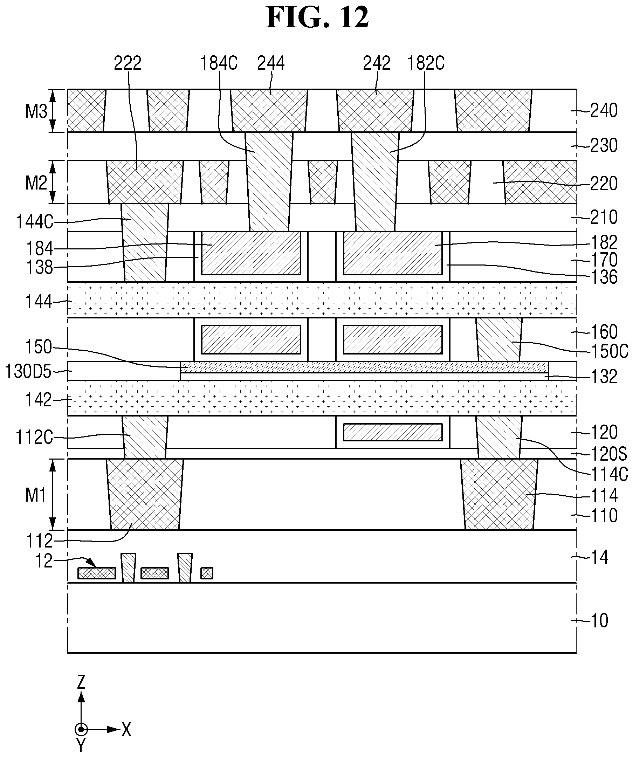

Referring to FIG. 12, the semiconductor memory device according to some embodiments may further include a fifth insertion insulating film 130D5.

The fifth insertion insulating film 130D5 may be interposed between the first metal-oxide semiconductor film 142 and the second interlayer insulating film 160. The first gate dielectric film 132 and the charge storage film 150 may be formed in the fifth insertion insulating film 130D5. In some embodiments, the first gate dielectric film 132 may expose a portion of the upper surface of the first metal-oxide semiconductor film 142. For example, a length at which the first gate dielectric film 132 and the charge storage film 150 extend in the first direction X may be smaller than a length at which the first metal-oxide semiconductor film 142 extends in the first direction X.

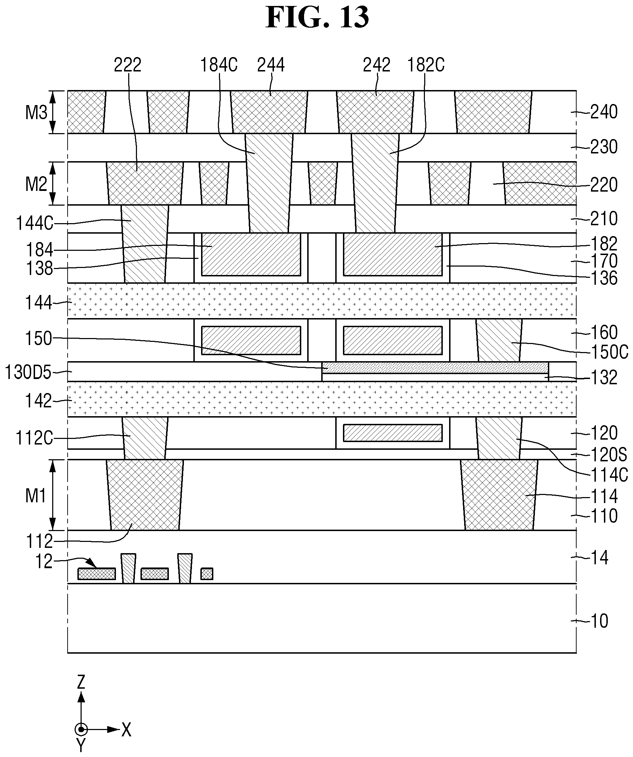

Referring to FIG. 13, in the semiconductor memory device according to some embodiments, the charge storage film 150 does not overlap the second gate electrode 184 in the second direction Z.

For example, the fifth insertion insulating film 130D5 may be formed between the first metal-oxide semiconductor film 142 and the second interlayer insulating film 160. The fifth insertion insulating film 130D5 may fill an area between the first metal-oxide semiconductor film 142 and the fourth gate dielectric film 138. The first gate dielectric film 132 and the charge storage film 150 may be formed in the fifth insertion insulating film 130D5. The charge storage film 150 may extend in the first direction X between the first metal-oxide semiconductor film 142 and the first gate electrode 182 and between the first metal-oxide semiconductor film 142 and the third contact 150C, and may not extend between the first metal-oxide semiconductor film 142 and the second gate electrode 184.

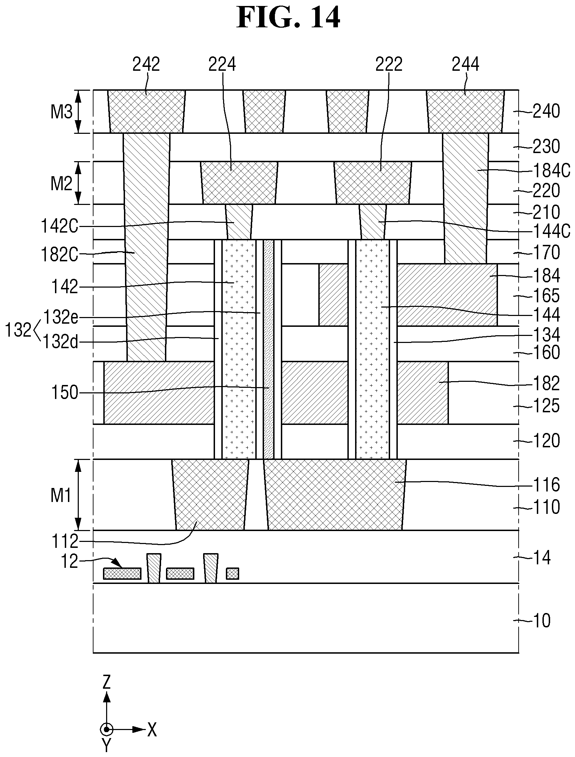

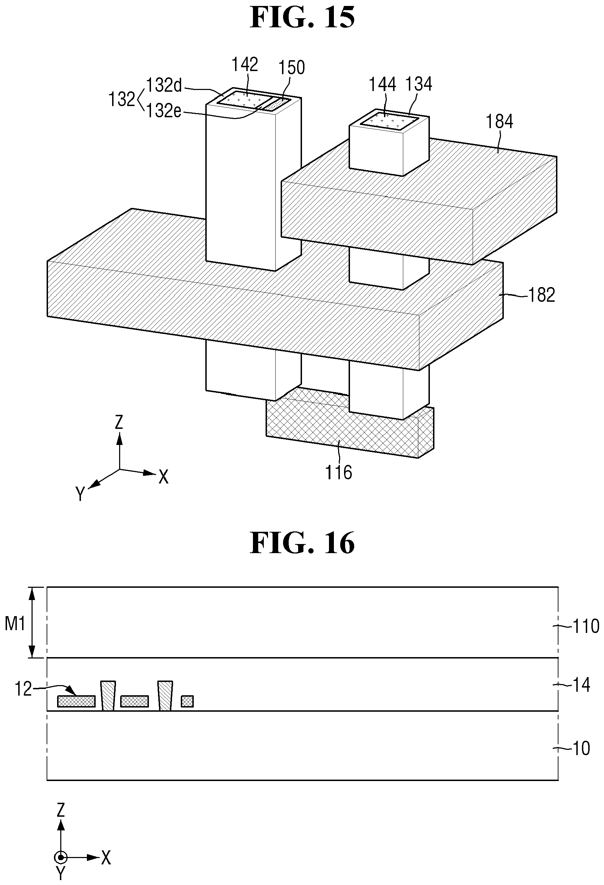

FIG. 14 is a cross-sectional view illustrating a semiconductor memory device according to some embodiments. FIG. 15 is a partial perspective view illustrating the semiconductor memory device of FIG. 14. For convenience of explanation, portions of the description that may overlap with the description of FIGS. 1 to 13 may be briefly described or omitted.

Referring to FIGS. 1, 14, and 15, in the semiconductor memory device according to some embodiments, the first metal-oxide semiconductor film 142 and the second metal-oxide semiconductor film 144 may each extend in the second direction Z.

For example, the first metal-oxide semiconductor film 142 and the second metal-oxide semiconductor film 144 may each extend in the second direction Z to penetrate through the first interlayer insulating film 120, a second interlayer insulating film 160, and the third interlayer insulating film 170. In some embodiments, the first metal-oxide semiconductor film 142 and the second metal-oxide semiconductor film 144 may be arranged along the first direction X.

In some embodiments, the first metal-oxide semiconductor film 142 may be connected to the first wiring pattern 112. For example, the first metal-oxide semiconductor film 142 may extend in the second direction Z and be connected to the upper surface of the first wiring pattern 112. The first wiring pattern 112 may be provided as the ground line (or Vss) of FIG. 1, and the first metal-oxide semiconductor film 142 may be provided as a channel of the first transistor RTr of FIG. 1.

The first gate dielectric film 132 may be formed on the first metal-oxide semiconductor film 142. The first gate dielectric film 132 may cover at least a portion of a surface of the first metal-oxide semiconductor film 142. For example, the first gate dielectric film 132 may extend along a perimeter of the first metal-oxide semiconductor film 142.

In some embodiments, the first gate dielectric film 132 may include a sixth sub-dielectric film 132d and a seventh sub-dielectric film 132e. The sixth sub-dielectric film 132d may extend along the perimeter of the first metal-oxide semiconductor film 142 (e.g., a surface defining the perimeter of a cross-section of the first metal-oxide semiconductor film 142 as shown in FIG. 15). The seventh sub-dielectric film 132e may be formed in the sixth sub-dielectric film 132d and may extend in the second direction Z along one side surface of the first metal-oxide semiconductor film 142. The sixth sub-dielectric film 132d and the seventh sub-dielectric film 132e may be formed of and/or include the same dielectric material as one another or different dielectric materials. It is illustrated in FIGS. 14 and 15 that a boundary exists between the sixth sub-dielectric film 132d and the seventh sub-dielectric film 132e, but this is only an example, and in some cases, the boundary may not exist between the sixth sub-dielectric film 132d and the seventh sub-dielectric film 132e. For example, the sixth sub-dielectric film 132d and the seventh sub-dielectric film 132e may be formed of the same material using the same process so as to not have a boundary.

The charge storage film 150 is formed within the first gate dielectric film 132. The charge storage film 150 may be spaced apart from the first metal-oxide semiconductor film 142 by the first gate dielectric film 132. For example, the charge storage film 150 may be interposed between the sixth sub-dielectric film 132d and the seventh sub-dielectric film 132e and extend in the second direction Z.

The second gate dielectric film 134 may be formed on the second metal-oxide semiconductor film 144. The second gate dielectric film 134 may cover at least a portion of a surface of the second metal-oxide semiconductor film 144. For example, the second gate dielectric film 134 may extend along a perimeter of the second metal-oxide semiconductor film 144 (e.g., a surface defining the perimeter of a cross-section of the second metal-oxide semiconductor film 144 as shown in FIG. 15).

The second metal-oxide semiconductor film 144 is connected to the charge storage film 150. For example, the first wiring structure M1 may include a connection pattern 116 within the first inter-wiring insulating film 110. The connection pattern 116 may be spaced apart from the first wiring pattern 112 by the first inter-wiring insulating film 110. The charge storage film 150 and the second metal-oxide semiconductor film 144 may each extend in the second direction Z and be connected to an upper surface of the connection pattern 116. That is, the charge storage film 150 and the second metal-oxide semiconductor film 144 may be connected through the connection pattern 116.

The first gate electrode 182 intersects the first metal-oxide semiconductor film 142 and the second metal-oxide semiconductor film 144. For example, a sixth interlayer insulating film 125 may be formed between the first interlayer insulating film 120 and the second interlayer insulating film 160. The first gate electrode 182 may be formed in the sixth interlayer insulating film 125. The first metal-oxide semiconductor film 142 and the second metal-oxide semiconductor film 144 may each extend in the second direction Z and penetrate through the first gate electrode 182.

The second gate electrode 184 is spaced apart from the first gate electrode 182. In some embodiments, the first gate electrode 182 and the second gate electrode 184 may be arranged along the second direction Z. The second gate electrode 184 intersects the second metal-oxide semiconductor film 144, and in an embodiment does not intersect the first metal-oxide semiconductor film 142. For example, a seventh interlayer insulating film 165 may be formed between the second interlayer insulating film 160 and the third interlayer insulating film 170. The second gate electrode 184 may be formed in the seventh interlayer insulating film 165. The first metal-oxide semiconductor film 142 may extend in the second direction Z and penetrate through the seventh interlayer insulating film 165, and the second metal-oxide semiconductor film 144 may extend in the second direction Z and penetrate through the second gate electrode 184.

At least a portion of the first gate dielectric film 132 is interposed between the first metal-oxide semiconductor film 142 and the first gate electrode 182. A portion of the second gate dielectric film 134 may be interposed between the second metal-oxide semiconductor film 144 and the first gate electrode 182. Another portion of the second gate dielectric film 134 is interposed between the second metal-oxide semiconductor film 144 and the second gate electrode 184. At least a portion of the charge storage film 150 may be interposed between the first metal-oxide semiconductor film 142 and the first gate electrode 182.

The second wiring structure M2 may include a third wiring pattern 222 and a sixth wiring pattern 224 spaced apart from each other within the second inter-wiring insulating film 220. In some embodiments, the third wiring pattern 222 may be connected to the second metal-oxide semiconductor film 144, and the sixth wiring pattern 224 may be connected to the first metal-oxide semiconductor film 142. For example, a seventh contact 142C penetrating through the fourth interlayer insulating film 210 and connected to the first metal-oxide semiconductor film 142 and to the sixth wiring pattern 224 may be formed. The sixth wiring pattern 224 may be provided as the first bit line RBL of FIG. 1. In addition, for example, an eighth contact 144C penetrating through the fourth interlayer insulating film 210 and connected to the second metal-oxide semiconductor film 144 and to the third wiring pattern 222 may be formed. The third wiring pattern 222 may be provided as the second bit line WBL of FIG. 1.

The third wiring structure M3 may include a fourth wiring pattern 242 and a fifth wiring pattern 244 spaced apart from each other within the third inter-wiring insulating film 240. In some embodiments, the fourth wiring pattern 242 may be connected to the first gate electrode 182, and the fifth wiring pattern 244 may be connected to the second gate electrode 184. For example, a fifth contact 182C penetrating through the second interlayer insulating film 160, the seventh interlayer insulating film 165, the third interlayer insulating film 170, the fourth interlayer insulating film 210, the second inter-wiring insulating film 220, and the fifth interlayer insulating film 230 and connected to the first gate electrode 182 and to the fourth wiring pattern 242 may be formed. The fourth wiring pattern 242 may be provided as the first word line WL1 of FIG. 1. In addition, for example, a sixth contact 184C penetrating through the third interlayer insulating film 170, the fourth interlayer insulating film 210, the second inter-wiring insulating film 220, and the fifth interlayer insulating film 230 and connected to the second gate electrode 184 and to the fifth wiring pattern 244 may be formed. The fifth wiring pattern 244 may be provided as the second word line WL2 of FIG. 1.

Hereinafter, a method for fabricating a semiconductor memory device according to embodiments will be described with reference to FIGS. 1 to 43.

FIGS. 16 to 29 are intermediate step views illustrating intermediate states of components during a method for fabricating a semiconductor memory device according to some embodiments. For convenience of explanation, portions of the description that may overlap with the description of FIGS. 1 to 15 may be briefly described or omitted.

Referring to FIG. 16, a circuit element 12, a lower insulating film 14, and a first inter-wiring insulating film 110 are formed on a substrate 10.

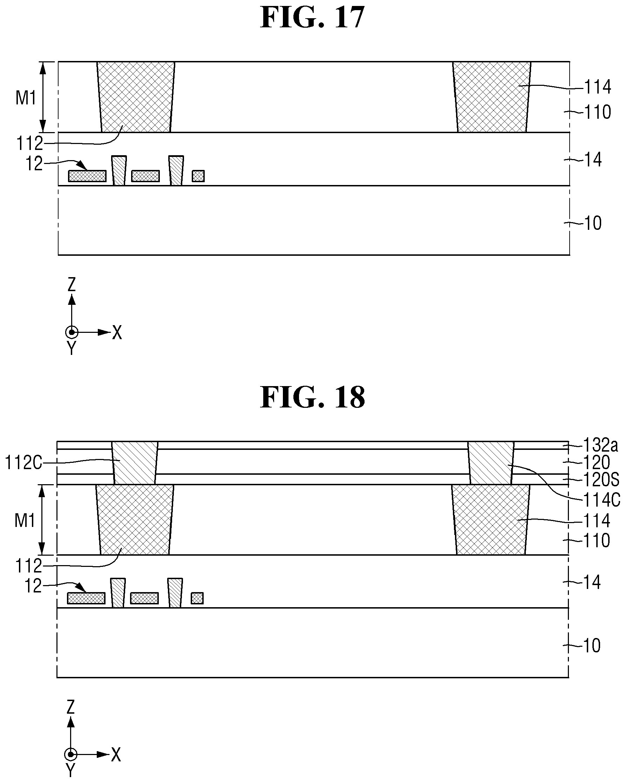

Referring to FIG. 17, a first wiring pattern 112 and a second wiring pattern 114 spaced apart from each other are formed within the first inter-wiring insulating film 110. Through this, a first wiring structure M1 including the first wiring pattern 112 and the second wiring pattern 114 may be provided.

Referring to FIG. 18, a first etch stop film 120S, a first interlayer insulating film 120, a first sub-dielectric film 132a, a first contact 112C, and a second contact 114C are formed on the first wiring structure M1.

For example, the first etch stop film 120S, the first interlayer insulating film 120, and the first sub-dielectric film 132a may be sequentially formed on the first wiring structure M1. Subsequently, the first contact 112C and the second contact 114C penetrating through the first etch stop film 120S, the first interlayer insulating film 120, and the first sub-dielectric film 132a may be formed. The first contact 112C may be connected to the first wiring pattern 112, and the second contact 114C may be connected to the second wiring pattern 114.

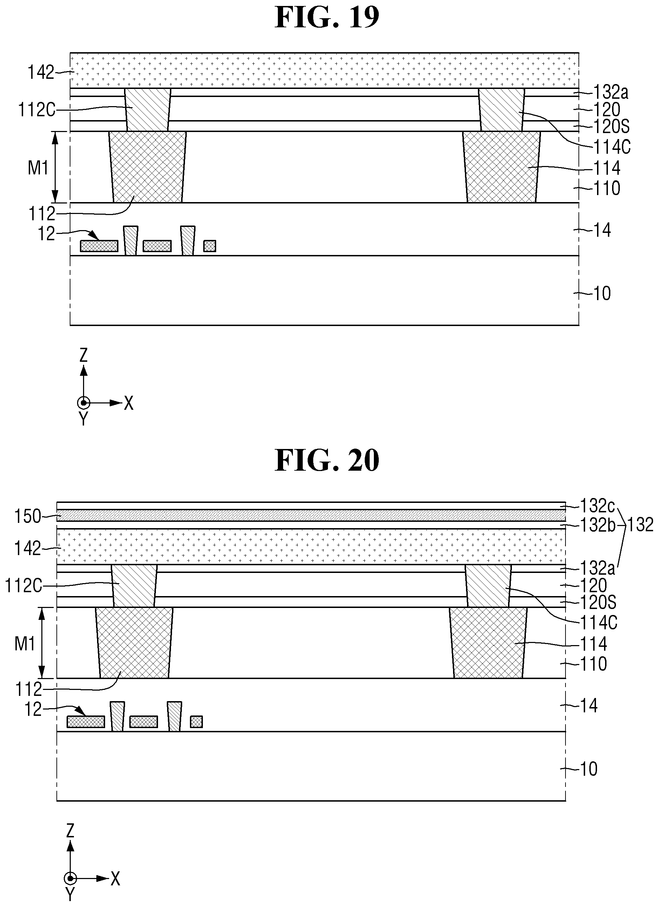

Referring to FIG. 19, a first metal-oxide semiconductor film 142 is formed on the first sub-dielectric film 132a, the first contact 112C, and the second contact 114C.

The first metal-oxide semiconductor film 142 may extend in a first direction X on an upper surface of the first sub-dielectric film 132a. In addition, the first metal-oxide semiconductor film 142 may be connected to the first contact 112C and the second contact 114C.

Referring to FIG. 20, a second sub-dielectric film 132b, a charge storage film 150, and a third sub-dielectric film 132c are formed on the first metal-oxide semiconductor film 142.

The second sub-dielectric film 132b, the charge storage film 150, and the third sub-dielectric film 132c may be sequentially formed on the first metal-oxide semiconductor film 142. Through this, a first gate dielectric film 132 including the first sub-dielectric film 132a, the second sub-dielectric film 132b, and the third sub-dielectric film 132c may be provided. In addition, the charge storage film 150 may be formed within the first gate dielectric film 132.

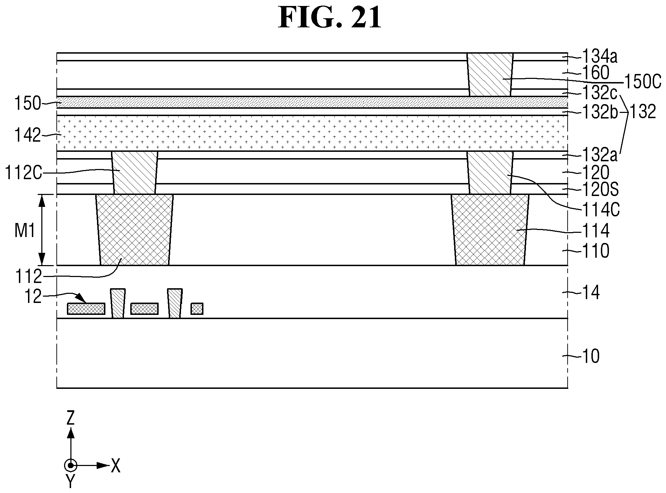

Referring to FIG. 21, a second interlayer insulating film 160, a fourth sub-dielectric film 134a, and a third contact 150C are formed on the first gate dielectric film 132.

For example, the second interlayer insulating film 160 and the fourth sub-dielectric film 134a may be sequentially formed on the first gate dielectric film 132. Subsequently, the third contact 150C penetrating through the third sub-dielectric film 132c, the second interlayer insulating film 160, and the fourth sub-dielectric film 134a and connected to the first metal-oxide semiconductor film 142 may be formed.

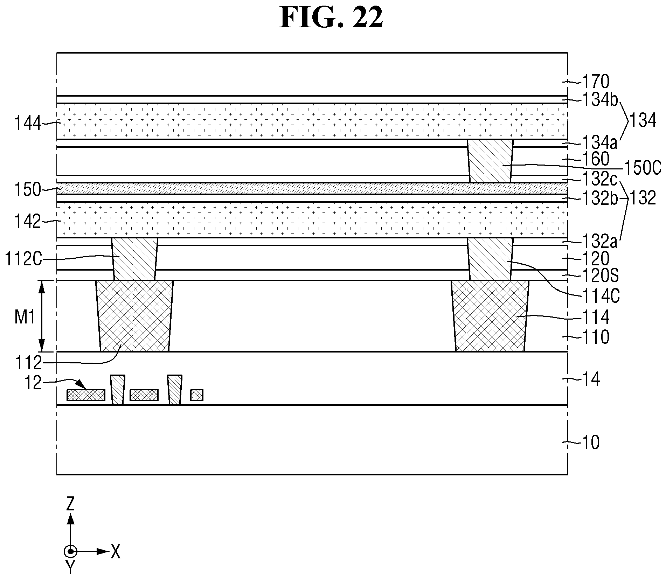

Referring to FIG. 22, a second metal-oxide semiconductor film 144, a fifth sub-dielectric film 134b, and a third interlayer insulating film 170 are formed on the fourth sub-dielectric film 134a and the third contact 150C.

For example, a second metal-oxide semiconductor film 144 extending in the first direction X may be formed on an upper surface of the fourth sub-dielectric film 134a. The second metal-oxide semiconductor film 144 may be connected to the third contact 150C. Subsequently, the fifth sub-dielectric film 134b and the third interlayer insulating film 170 may be formed on the second metal-oxide semiconductor film 144. Through the formation of the fourth sub-dielectric film 134a and the fifth sub-dielectric film 134b, a second gate dielectric film 134 including the fourth sub-dielectric film 134a and the fifth sub-dielectric film 134b may be provided.

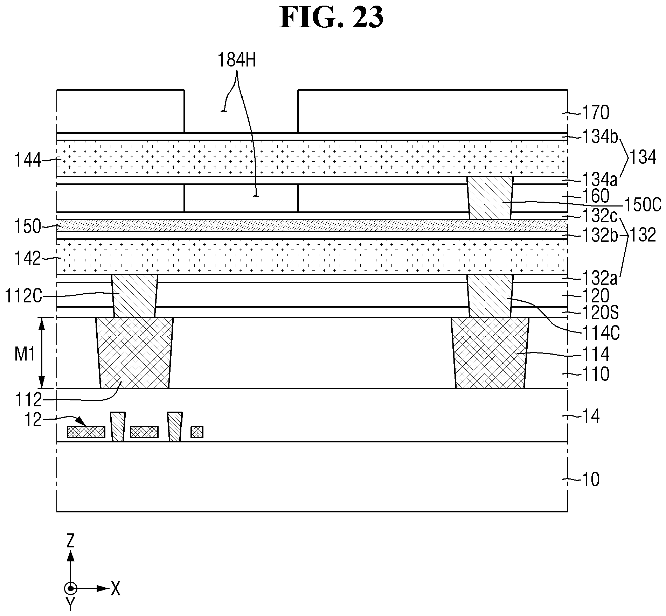

Referring to FIG. 23, a first through hole 184H exposing a portion of the second gate dielectric film 134 is formed.

The first through hole 184H may intersect the second metal-oxide semiconductor film 144, and may not intersect the first metal-oxide semiconductor film 142. For example, the first through hole 184H may extend in the second direction Z, and may penetrate through the second interlayer insulating film 160 and the third interlayer insulating film 170 and may not penetrate through the first interlayer insulating film 120. In some embodiments, the third sub-dielectric film 132c may be used as an etch stop film in an etching process for forming the first through hole 184H.

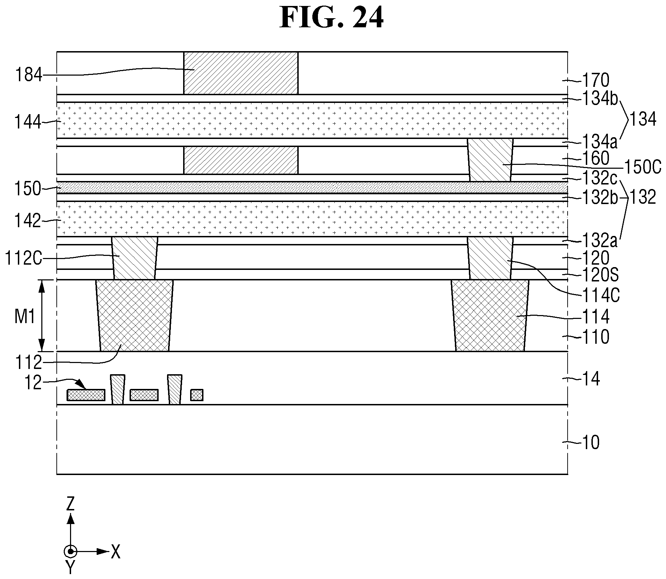

Referring to FIGS. 23 and 24, a second gate electrode 184 is formed within the first through hole 184H.

The second gate electrode 184 may fill the first through hole 184H. Through the formation of the second gate electrode 184 in the first through hole 184H, the second gate electrode 184 that intersects the second metal-oxide semiconductor film 144 and does not intersect the first metal-oxide semiconductor film 142 may be provided.

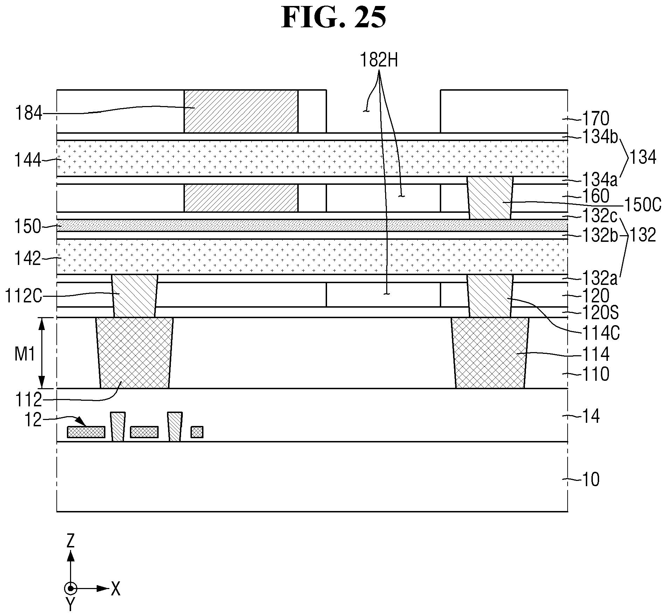

Referring to FIG. 25, a second through hole 182H exposing at least a portion of the first gate dielectric film 132 and another portion of the second gate dielectric film 134 is formed.

The second through hole 182H may intersect the first metal-oxide semiconductor film 142 and the second metal-oxide semiconductor film 144. For example, the second through hole 182H may extend in the second direction Z and penetrate through the first interlayer insulating film 120, the second interlayer insulating film 160, and the third interlayer insulating film 170. In some embodiments, the first etch stop film 120S may be used as an etch stop film in an etching process for forming the second through hole 182H.

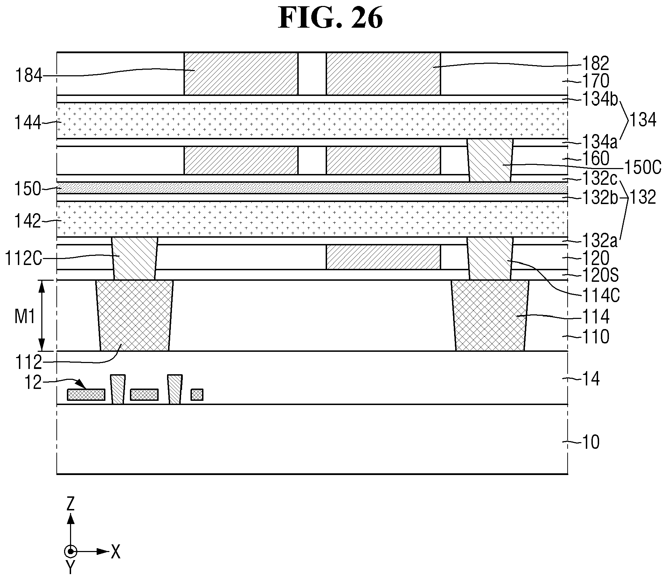

Referring to FIGS. 25 and 26, a first gate electrode 182 is formed within the second through hole 182H.

The first gate electrode 182 may fill the second through hole 182H. Through the filling of the second through hole 182H with the first gate electrode 182, the first gate electrode 182 that intersects the first metal-oxide semiconductor film 142 and the second metal-oxide semiconductor film 144 may be provided.

It is described that the first gate electrode 182 is formed after the second gate electrode 184 is formed, but this is only an example, and the first gate electrode 182 may also be formed before the second gate electrode 184 is formed. Alternatively, the first gate electrode 182 and the second gate electrode 184 may be simultaneously formed in-situ.

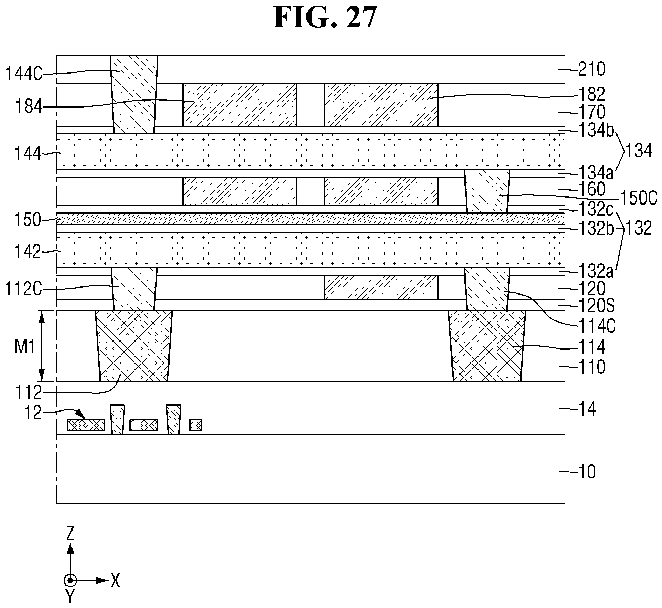

Referring to FIG. 27, a fourth interlayer insulating film 210 and a fourth contact 144C are formed.

For example, the fourth interlayer insulating film 210 covering the first gate electrode 182, the second gate electrode 184, and the third interlayer insulating film 170 may be formed. Subsequently, the fourth contact 144C penetrating through the fifth sub-dielectric film 134b, the third interlayer insulating film 170, and the fourth interlayer insulating film 210 and connected to the second metal-oxide semiconductor film 144 may be formed.

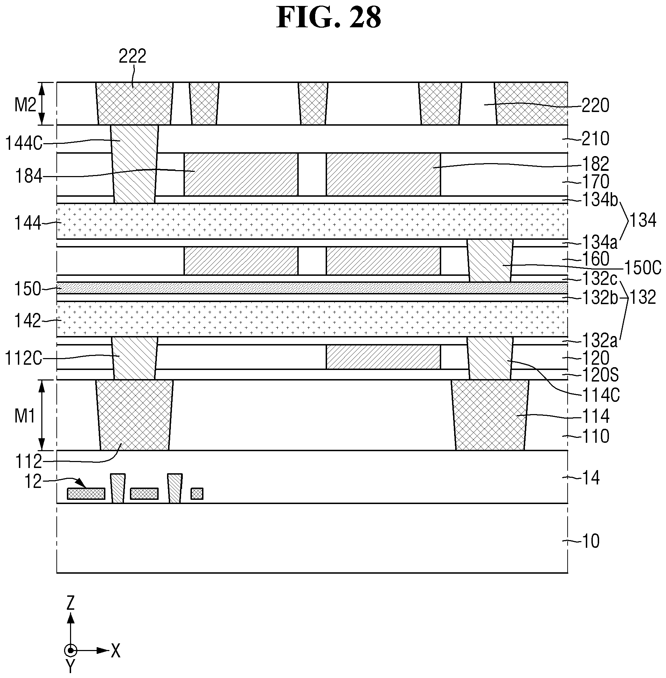

Referring to FIG. 28, a second wiring structure M2 is formed on the fourth interlayer insulating film 210 and the fourth contact 144C.

The second wiring structure M2 may include a second inter-wiring insulating film 220 and a third wiring pattern 222 within the second inter-wiring insulating film 220. The third wiring pattern 222 may be connected to the fourth contact 144C.

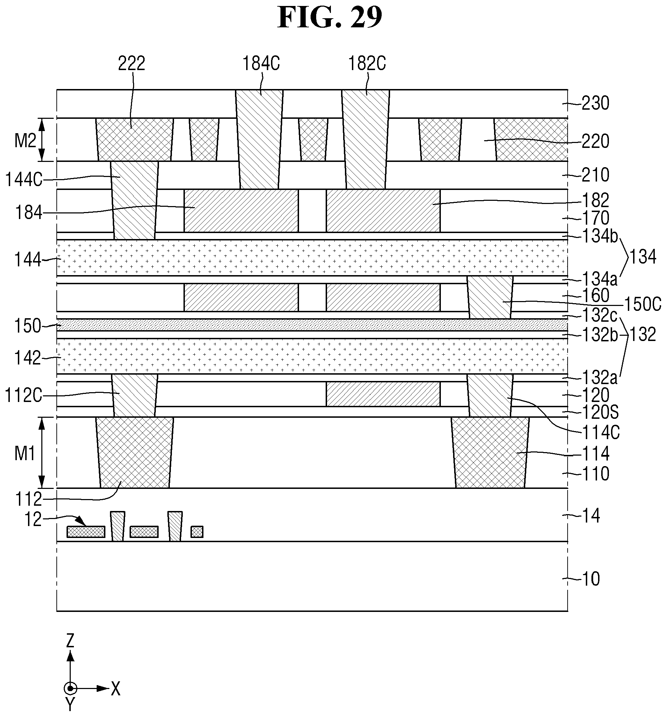

Referring to FIG. 29, a fifth interlayer insulating film 230, a fifth contact 182C, and a sixth contact 184C are formed.

For example, the fifth interlayer insulating film 230 covering the second wiring structure M2 may be formed. Subsequently, the fifth contact 182C and the sixth contact 184C penetrating through the fourth interlayer insulating film 210, the second inter-wiring insulating film 220, and the fifth interlayer insulating film 230 may be formed. The fifth contact 182C may be connected to the first gate electrode 182, and the sixth contact 184C may be connected to the second gate electrode 184.

Next, referring to FIG. 2, a third wiring structure M3 is formed on the fifth interlayer insulating film 230, the fifth contact 182C, and the sixth contact 184C. Through this method described with reference to FIGS. 16-29, the semiconductor memory device described above with reference to FIGS. 1 to 4 may be fabricated.

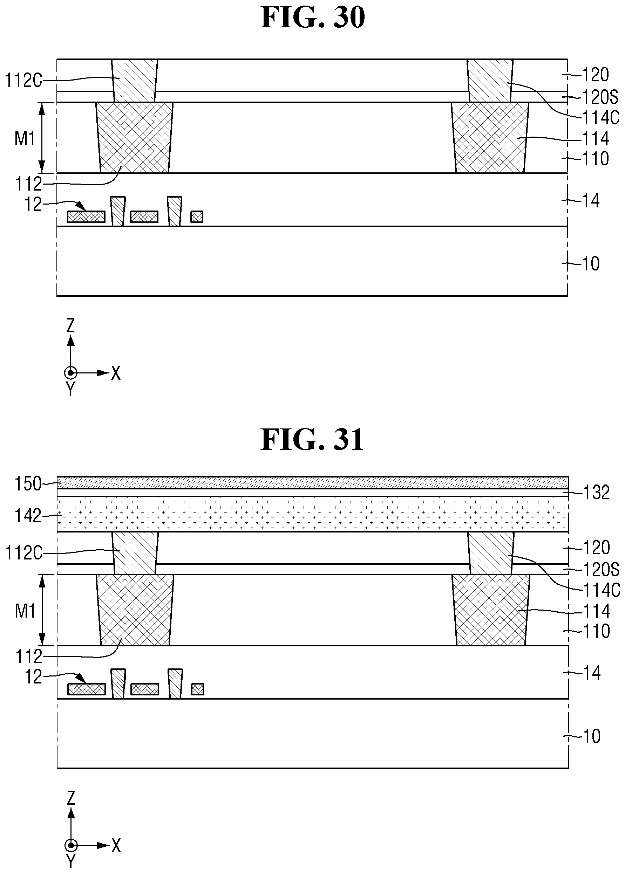

FIGS. 30 to 36 are intermediate step views illustrating a method for fabricating a semiconductor memory device according to some embodiments. For convenience of explanation, portions of the description that may overlap with the description previously provided with reference to FIGS. 1 to 29 may be briefly described or omitted. For reference, FIG. 30 is view of an intermediate state in a process of fabricating a semiconductor memory device that may proceed after the state shown in FIG. 17.

Referring to FIG. 30, a first etch stop film 120S, a first interlayer insulating film 120, a first contact 112C, and a second contact 114C are formed on the first wiring structure M1. Since the formation of the first etch stop film 120S, the first interlayer insulating film 120, the first contact 112C, and the second contact 114C may be performed similar to that described above with reference to FIG. 18, a detailed description thereof may not be provided below.

Referring to FIG. 31, a first metal-oxide semiconductor film 142, a first gate dielectric film 132, and a charge storage film 150 are formed on the first interlayer insulating film 120, the first contact 112C, and the second contact 114C.

The first metal-oxide semiconductor film 142 may extend in a first direction X on an upper surface of the first sub-dielectric film 132a. In addition, the first metal-oxide semiconductor film 142 may be connected to the first contact 112C and the second contact 114C. The first gate dielectric film 132 and the charge storage film 150 may be sequentially stacked on the first metal-oxide semiconductor film 142.

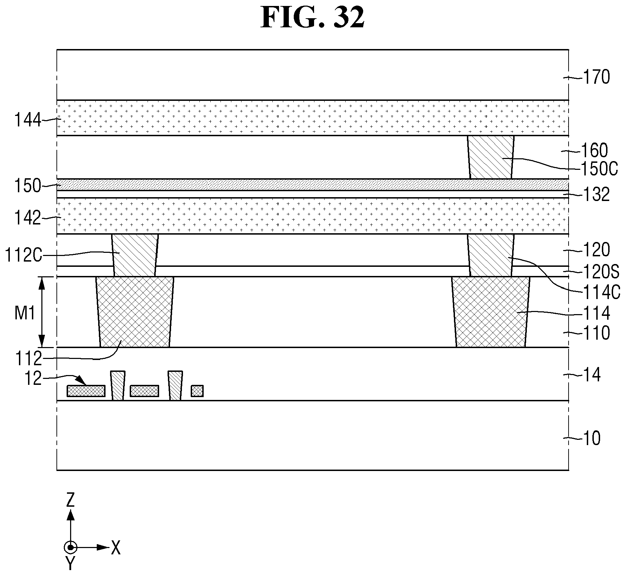

Referring to FIG. 32, a second interlayer insulating film 160, a third contact 150C, a second metal-oxide semiconductor film 144, and a third interlayer insulating film 170 are formed.

The second interlayer insulating film 160 may be formed on the charge storage film 150. The third contact 150C may penetrate through the second interlayer insulating film 160 and be connected to the charge storage film 150. Subsequently, a second metal-oxide semiconductor film 144 extending in the first direction X may be formed on an upper surface of the second interlayer insulating film 160. The second metal-oxide semiconductor film 144 may be connected to the third contact 150C. Subsequently, a third interlayer insulating film 170 may be formed on the second metal-oxide semiconductor film 144.

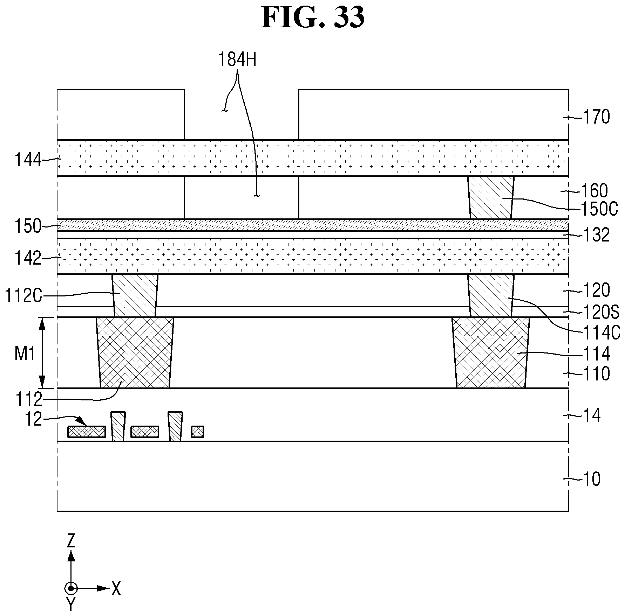

Referring to FIG. 33, a first through hole 184H exposing a portion of the second metal-oxide semiconductor film 144 is formed.

The first through hole 184H may intersect the second metal-oxide semiconductor film 144, and may not intersect the first metal-oxide semiconductor film 142. For example, the first through hole 184H may extend in the second direction Z, and may penetrate through the second interlayer insulating film 160 and the third interlayer insulating film 170 and may not penetrate through the first interlayer insulating film 120. In some embodiments, the charge storage film 150 may be used as an etch stop film in an etching process for forming the first through hole 184H.

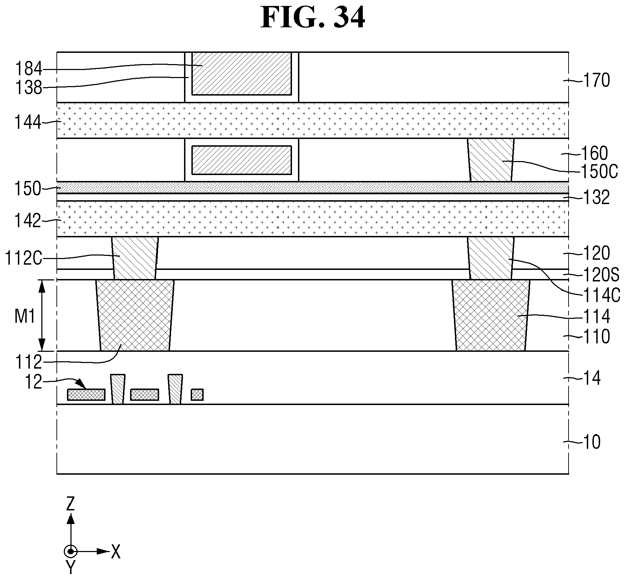

Referring to FIGS. 33 and 34, a fourth gate dielectric film 138 and the second gate electrode 184 are formed within the first through hole 184H.

The fourth gate dielectric film 138 and the second gate electrode 184 may be sequentially formed in the first through hole 184H. Through the formation of the fourth gate dielectric film 138 and the second gate electrode 184 in the first through hole 184H, the second gate electrode 184 that intersects the second metal-oxide semiconductor film 144 and does not intersect the first metal-oxide semiconductor film 142 may be provided.

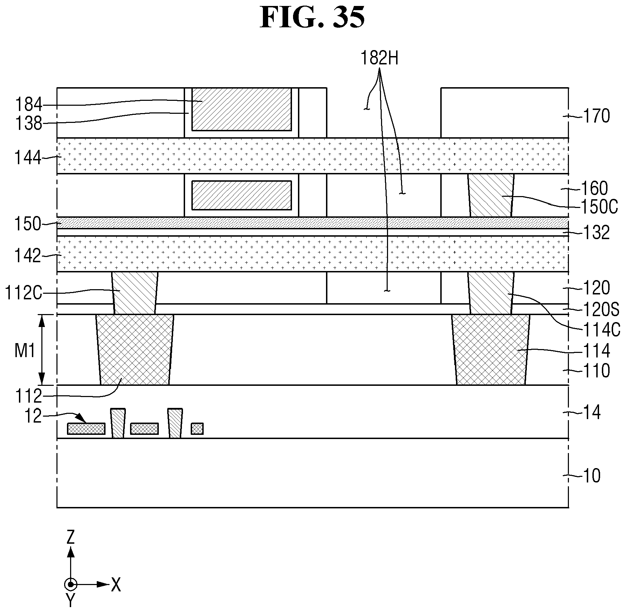

Referring to FIG. 35, a second through hole 182H exposing at least a portion of the first metal-oxide semiconductor film 142, at least a portion of the charge storage film 150, and another portion of the second metal-oxide semiconductor film 144 is formed.

The second through hole 182H may intersect the first metal-oxide semiconductor film 142 and the second metal-oxide semiconductor film 144. For example, the second through hole 182H may extend in the second direction Z and penetrate through the first interlayer insulating film 120, the second interlayer insulating film 160, and the third interlayer insulating film 170. In some embodiments, the first etch stop film 120S may be used as an etch stop film in an etching process for forming the second through hole 182H.

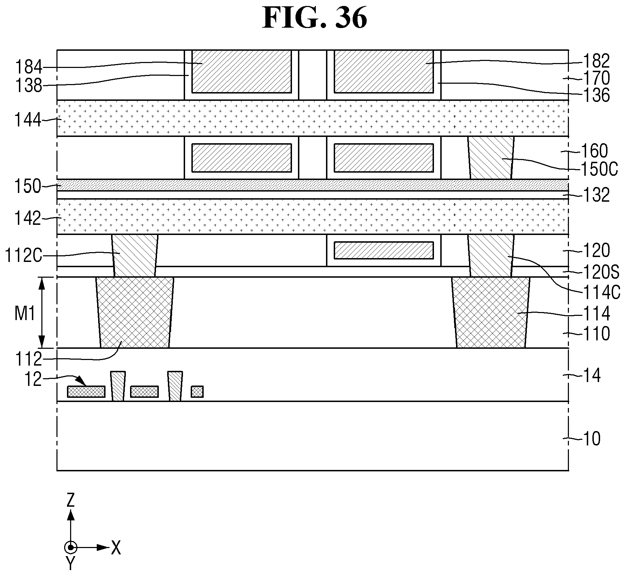

Referring to FIGS. 35 and 36, a third gate dielectric film 136 and a first gate electrode 182 are formed within the second through hole 182H.

The third gate dielectric film 136 and the first gate electrode 182 may be sequentially formed in the second through hole 182H. Through the formation of the third gate dielectric film 136 and the first gate electrode 182, the first gate electrode 182 that intersects the first metal-oxide semiconductor film 142 and the second metal-oxide semiconductor film 144 may be provided.

It is described that the first gate electrode 182 is formed after the second gate electrode 184 is formed, but this is only an example, and the first gate electrode 182 may also be formed before the second gate electrode 184 is formed. Alternatively, the first gate electrode 182 and the second gate electrode 184 may be simultaneously formed in-situ.

Subsequently, the steps described above with reference to FIGS. 27 to 29, and 2 may be performed. Through these steps, the semiconductor memory device described above with reference to FIGS. 8 to 10 may be fabricated.

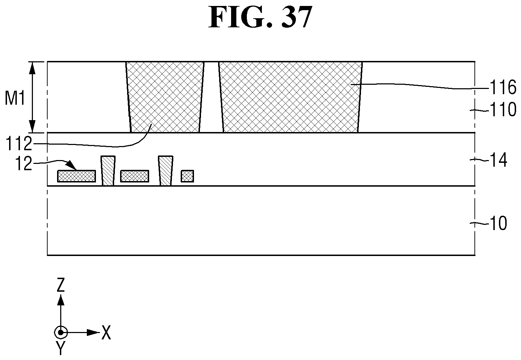

FIGS. 37 to 43 are intermediate step views illustrating a method for fabricating a semiconductor memory device according to some embodiments. For convenience of explanation, portions of the description that may overlap with the previously provided description with reference to FIGS. 1 to 36 may be briefly described or omitted.

Referring to FIG. 37, a circuit element 12, a lower insulating film 14, and a first wiring structure M1 are formed on a substrate 10.

The first wiring structure M1 may be formed on the lower insulating film 14. The first wiring structure M1 may include a first wiring pattern 112 and a connection pattern 116 spaced apart from each other within the first inter-wiring insulating film 110.

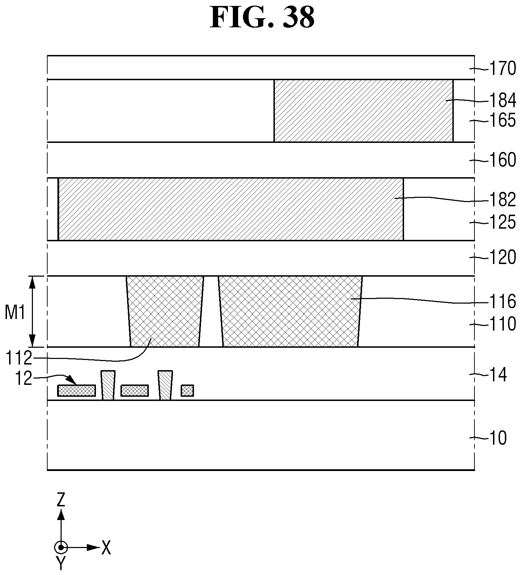

Referring to FIG. 38, a first interlayer insulating film 120, a sixth interlayer insulating film 125, a first gate electrode 182, a second interlayer insulating film 160, a seventh interlayer insulating film 165, a second gate electrode 184, and a third interlayer insulating film 170 are formed on the first wiring structure M1.

For example, the first interlayer insulating film 120 and the sixth interlayer insulating film 125 may be sequentially formed on the first wiring structure M1. The first gate electrode 182 may be formed in the sixth interlayer insulating film 125. Subsequently, the second interlayer insulating film 160 and the seventh interlayer insulating film 165 may be sequentially formed on the first gate electrode 182 and the sixth interlayer insulating film 125. The second gate electrode 184 may be formed in the seventh interlayer insulating film 165. Subsequently, the third interlayer insulating film 170 may be formed on the second gate electrode 184 and the seventh interlayer insulating film 165.

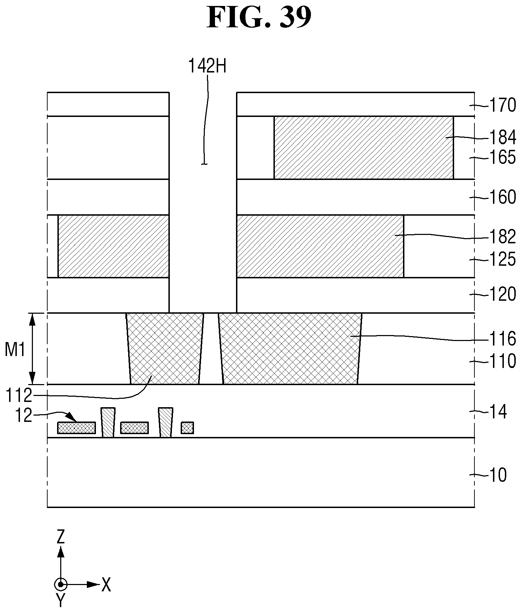

Referring to FIG. 39, a third through hole 142H exposing at least a portion of the first wiring pattern 112 and a portion of the connection pattern 116 is formed.

The third through hole 142H may intersect the first gate electrode 182, and may not intersect the second gate electrode 184. For example, the third through hole 142H may extend in the second direction Z and penetrate through the first interlayer insulating film 120, the first gate electrode 182, the second interlayer insulating film 160, the seventh interlayer insulating film 165, and the third interlayer insulating film 170.

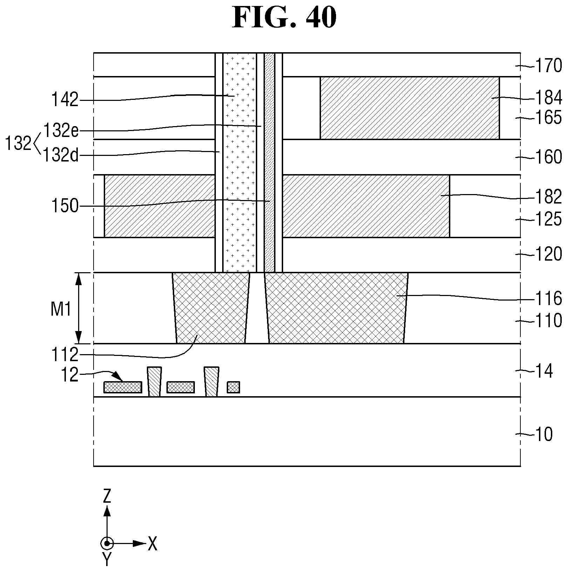

Referring to FIGS. 39 and 40, a first metal-oxide semiconductor film 142, a first gate dielectric film 132, and a charge storage film 150 are formed within the third through hole 142H.

The first metal-oxide semiconductor film 142, the first gate dielectric film 132, and the charge storage film 150 may fill the third through hole 142H. Through the filling of the third through hole 142H with the first metal-oxide semiconductor film 142, the first gate dielectric film 132, and the charge storage film 150, the first metal-oxide semiconductor film 142 that intersects the first gate electrode 182 and does not intersect the second gate electrode 184 may be provided. The first metal-oxide semiconductor film 142 may be connected to the first wiring pattern 112. The charge storage film 150 may be connected to the connection pattern 116.

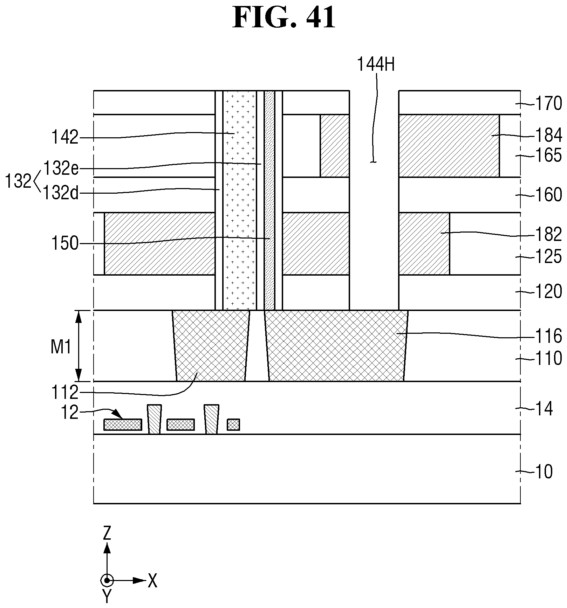

Referring to FIG. 41, a fourth through hole 144H exposing another portion of the connection pattern 116 is formed.

The fourth through hole 144H may intersect the first gate electrode 182 and the second gate electrode 184. For example, the fourth through hole 144H may extend in the second direction Z and penetrate through the first interlayer insulating film 120, the first gate electrode 182, the second interlayer insulating film 160, the second gate electrode 184, and the third interlayer insulating film 170.

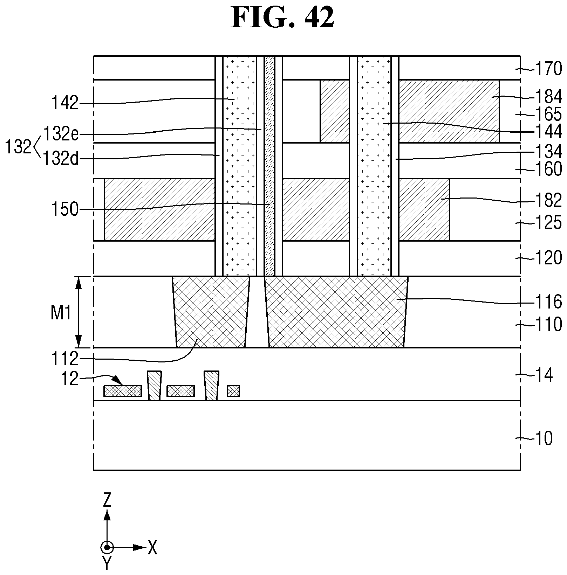

Referring to FIGS. 41 and 42, a second metal-oxide semiconductor film 144 and a second gate dielectric film 134 are formed within the fourth through hole 144H.

The second metal-oxide semiconductor film 144 and second gate dielectric film 134 may fill the fourth through hole 144H. Through the filling of the fourth through hole 144H with the second metal-oxide semiconductor film 144 and second gate dielectric film 134, the second metal-oxide semiconductor film 144 that intersects the first gate electrode 182 and the second gate electrode 184 may be provided. The second metal-oxide semiconductor film 144 may be connected to the connection pattern 116.

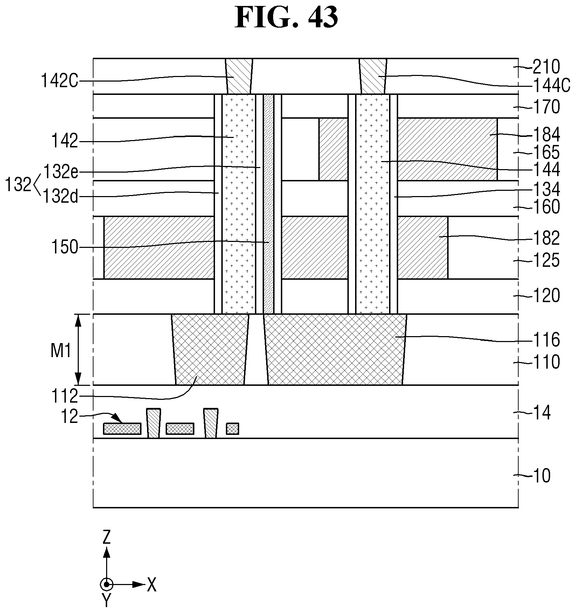

Referring to FIG. 43, a fourth interlayer insulating film 210, a seventh contact 142C, and an eighth contact 144C are formed on the third interlayer insulating film 170, the first metal-oxide semiconductor film 142, and the second metal-oxide semiconductor film 144.

For example, the fourth interlayer insulating film 210 may be formed on the third interlayer insulating film 170, the first metal-oxide semiconductor film 142, and the second metal-oxide semiconductor film 144. Subsequently, the seventh contact 142C and the eighth contact 144C penetrating through the fourth interlayer insulating film 210 may be formed. The seventh contact 142C may be connected to the first metal-oxide semiconductor film 142, and the eighth contact 144C may be connected to the second metal-oxide semiconductor film 144.

Subsequently, referring to FIG. 14, a second wiring structure M2 and a third wiring structure M3 are formed on the fourth interlayer insulating film 210, the seventh contact 142C, and the eighth contact 144C. Through these steps, the semiconductor memory device described above with reference to FIGS. 14 and 15 may be fabricated.

While the present inventive concept has been particularly shown and described with reference to embodiments thereof, it will be understood by those of ordinary skill in the art that various changes in form and details may be made therein without departing from the scope of the present inventive concept as defined by the following claims. It is therefore desired that the present embodiments be considered in all respects as illustrative and not restrictive, reference being made to the appended claims rather than the foregoing description to indicate the scope of the invention.

Embodiments of the invention include :
Clause 1. A semiconductor memory device comprising:
   a first metal-oxide semiconductor film; a second metal-oxide semiconductor film spaced apart from the first metal-oxide semiconductor film; a first gate electrode intersecting the first metal-oxide semiconductor film and the second metal-oxide semiconductor film; a first gate dielectric film interposed between the first metal-oxide semiconductor film and the first gate electrode; a charge storage film in the first gate dielectric film, the charge storage film extending along at least a portion of the first metal-oxide semiconductor film and connected to the second metal-oxide semiconductor film; a second gate electrode spaced apart from the first gate electrode and intersecting the second metal-oxide semiconductor film; and a second gate dielectric film interposed between the second metal-oxide semiconductor film and the second gate electrode.
Clause 2. The semiconductor memory device of clause 1, wherein the second gate electrode does not intersect the first metal-oxide semiconductor film.
Clause 3. The semiconductor memory device of clause 1 or 2, wherein the first gate dielectric film includes a first sub-dielectric film covering a lower surface of the first metal-oxide semiconductor film, a second sub-dielectric film covering an upper surface of the first metal-oxide semiconductor film, and a third sub-dielectric film covering an upper surface of the second sub-dielectric film, and
   the charge storage film is interposed between the second sub-dielectric film and the third sub-dielectric film.
Clause 4. The semiconductor memory device of clause 3, further comprising a contact penetrating through the third sub-dielectric film and the second gate dielectric film, the contact connected to the charge storage film and to the second metal-oxide semiconductor film.
Clause 5. The semiconductor memory device of any one preceding clause, wherein the second gate dielectric film includes a first sub-dielectric film covering a lower surface of the second metal-oxide semiconductor film, and a second sub-dielectric film covering a side surface and an upper surface of the second metal-oxide semiconductor film.
Clause 6. The semiconductor memory device of any one preceding clause, further comprising: a substrate; a circuit element on the substrate; a lower insulating film on the substrate, the lower insulating film covering the circuit element; and a first wiring structure and a second wiring structure sequentially stacked on the lower insulating film, wherein the first metal-oxide semiconductor film, the second metal-oxide semiconductor film, the first gate electrode, and the second gate electrode are each interposed between the first wiring structure and the second wiring structure.
Clause 7. The semiconductor memory device of clause 6, wherein the first wiring structure includes a first wiring pattern and a second wiring pattern spaced apart from each other, and
   the first metal-oxide semiconductor film is connected to the first wiring pattern and the second wiring pattern.
Clause 8. The semiconductor memory device of clause 7, wherein the second wiring structure includes a third wiring pattern connected to the second metal-oxide semiconductor film.
Clause 9. The semiconductor memory device of clause 8, further comprising a third wiring structure stacked on the second wiring structure, wherein the third wiring structure includes a fourth wiring pattern connected to the first gate electrode and a fifth wiring pattern connected to the second gate electrode.
Clause 10. The semiconductor memory device of any one preceding clause, wherein each of the first metal-oxide semiconductor film and the second metal-oxide semiconductor film includes indium gallium zinc oxide (IGZO).
Clause 11. The semiconductor memory device of any one preceding clause, wherein the charge storage film includes at least one of polysilicon or silicon nitride.
Clause 12. A semiconductor memory device comprising:
   a substrate; a circuit element on the substrate; a lower insulating film on the substrate, the lower insulating film covering the circuit element; a first wiring structure on the lower insulating film, the first wiring structure including a first wiring pattern and a second wiring pattern spaced apart from each other; a first metal-oxide semiconductor film on the first wiring structure, the first metal-oxide semiconductor film connected to the first wiring pattern and the second wiring pattern; a second metal-oxide semiconductor film on the first wiring structure, the second metal-oxide semiconductor film spaced apart from the first metal-oxide semiconductor film; a first gate electrode intersecting the first metal-oxide semiconductor film and the second metal-oxide semiconductor film; a charge storage film between the first metal-oxide semiconductor film and the first gate electrode, the charge storage film connected to the second metal-oxide semiconductor film; a second gate electrode intersecting the second metal-oxide semiconductor film and not intersecting the first metal-oxide semiconductor film; a second wiring structure on the first gate electrode and the second gate electrode, the second wiring structure including a third wiring pattern connected to the second metal-oxide semiconductor film; and a third wiring structure on the second wiring structure, the third wiring structure including a fourth wiring pattern connected to the first gate electrode and a fifth wiring pattern connected to the second gate electrode.
Clause 13. The semiconductor memory device of clause 12, wherein each of the first metal-oxide semiconductor film and the second metal-oxide semiconductor film extends in a first direction parallel to an upper surface of the substrate, and each of the first gate electrode and the second gate electrode extends in a second direction intersecting the upper surface of the substrate.
Clause 14. The semiconductor memory device of clause 13, wherein the first metal-oxide semiconductor film extends in the first direction and penetrates through the first gate electrode, and the second metal-oxide semiconductor film extends in the first direction and penetrates through the first gate electrode and the second gate electrode.
Clause 15. The semiconductor memory device of clause 13 or 14, wherein the first metal-oxide semiconductor film and the second metal-oxide semiconductor film are spaced apart from each other in the second direction, and the first gate electrode and the second gate electrode are spaced apart from each other in the first direction.
Clause 16. The semiconductor memory device of any one of clauses 12 to 15, wherein the charge storage film extends along at least a portion of an upper surface of the first metal-oxide semiconductor film.
Clause 17. The semiconductor memory device of any one of clauses 12 to 16, further comprising: a first contact connected to the first wiring pattern and to the first metal-oxide semiconductor film; and a second contact connected to the second wiring pattern and to the first metal-oxide semiconductor film, wherein the first gate electrode intersects the first metal-oxide semiconductor film between the first contact and the second contact.
Clause 18. The semiconductor memory device of any one of clauses 12 to 17, further comprising: a first contact connected to the charge storage film and to the second metal-oxide semiconductor film; and a second contact connected to the second metal-oxide semiconductor film and to the third wiring pattern, wherein each of the first gate electrode and the second gate electrode intersects the second metal-oxide semiconductor film between the first contact and the second contact.
Clause 19. The semiconductor memory device of any one of clauses 12 to 18, wherein each of the first metal-oxide semiconductor film and the second metal-oxide semiconductor film includes indium gallium zinc oxide (IGZO).
Clause 20. A semiconductor memory device comprising: a substrate; a circuit element on the substrate; a lower insulating film on the substrate, the lower insulating film covering the circuit element; a first wiring structure on the lower insulating film, the first wiring structure including a first wiring pattern and a connection pattern spaced apart from each other; a first gate electrode on the first wiring structure, the first gate electrode spaced apart from the first wiring structure; a second gate electrode on the first gate electrode, the second gate electrode spaced apart from the first gate electrode; a first metal-oxide semiconductor film intersecting the first gate electrode and connected to the first wiring pattern; a charge storage film between the first gate electrode and the first metal-oxide semiconductor film, the charge storage film connected to the connection pattern; a second metal-oxide semiconductor film intersecting the first gate electrode and the second gate electrode, and connected to the connection pattern; a second wiring structure on the first metal-oxide semiconductor film and the second metal-oxide semiconductor film, the second wiring structure including a second wiring pattern connected to the first metal-oxide semiconductor film and a third wiring pattern connected to the second metal-oxide semiconductor film; and a third wiring structure on the second wiring structure, the third wiring structure including a fourth wiring pattern connected to the first gate electrode and a fifth wiring pattern connected to the second gate electrode.
Clause 21. The semiconductor memory device of clause 20, wherein the first metal-oxide semiconductor film does not intersect the second gate electrode.
Clause 22. The semiconductor memory device of clause 20 or 21, wherein each of the first gate electrode and the second gate electrode extends in a first direction parallel to an upper surface of the substrate, and each of the first metal-oxide semiconductor film and the second metal-oxide semiconductor film extends in a second direction intersecting the upper surface of the substrate.
Clause 23. The semiconductor memory device of clause 22, wherein the first metal-oxide semiconductor film extends in the second direction and penetrates through the first gate electrode, and the second metal-oxide semiconductor film extends in the second direction and penetrates through the first gate electrode and the second gate electrode.
Clause 24. The semiconductor memory device of any one of clauses 20 to 23, wherein the charge storage film extends along at least a portion of a side surface of the first metal-oxide semiconductor film.
Clause 25. The semiconductor memory device of any one of clauses 20 to 24, wherein each of the first metal-oxide semiconductor film and the second metal-oxide semiconductor film includes indium gallium zinc oxide (IGZO).

## Claims

1. A semiconductor memory device comprising:
a first metal-oxide semiconductor film;
a second metal-oxide semiconductor film spaced apart from the first metal-oxide semiconductor film;
a first gate electrode intersecting the first metal-oxide semiconductor film and the second metal-oxide semiconductor film;
a first gate dielectric film interposed between the first metal-oxide semiconductor film and the first gate electrode;
a charge storage film in the first gate dielectric film, the charge storage film extending along at least a portion of the first metal-oxide semiconductor film and connected to the second metal-oxide semiconductor film;
a second gate electrode spaced apart from the first gate electrode and intersecting the second metal-oxide semiconductor film; and
a second gate dielectric film interposed between the second metal-oxide semiconductor film and the second gate electrode.

2. The semiconductor memory device of claim 1, wherein the second gate electrode does not intersect the first metal-oxide semiconductor film.

3. The semiconductor memory device of claim 1 or 2, wherein the first gate dielectric film includes a first sub-dielectric film covering a lower surface of the first metal-oxide semiconductor film, a second sub-dielectric film covering an upper surface of the first metal-oxide semiconductor film, and a third sub-dielectric film covering an upper surface of the second sub-dielectric film, and
the charge storage film is interposed between the second sub-dielectric film and the third sub-dielectric film.

4. The semiconductor memory device of claim 3, further comprising a contact penetrating through the third sub-dielectric film and the second gate dielectric film, the contact connected to the charge storage film and to the second metal-oxide semiconductor film.

5. The semiconductor memory device of any one of claims 1 to 4, wherein the second gate dielectric film includes a first sub-dielectric film covering a lower surface of the second metal-oxide semiconductor film, and a second sub-dielectric film covering a side surface and an upper surface of the second metal-oxide semiconductor film.

6. The semiconductor memory device of any one of claims 1 to 5, further comprising:
a substrate;
a circuit element on the substrate;
a lower insulating film on the substrate, the lower insulating film covering the circuit element; and
a first wiring structure and a second wiring structure sequentially stacked on the lower insulating film,
wherein the first metal-oxide semiconductor film, the second metal-oxide semiconductor film, the first gate electrode, and the second gate electrode are each interposed between the first wiring structure and the second wiring structure.

7. The semiconductor memory device of claim 6, wherein the first wiring structure includes a first wiring pattern and a second wiring pattern spaced apart from each other, and
the first metal-oxide semiconductor film is connected to the first wiring pattern and the second wiring pattern.

8. The semiconductor memory device of claim 7, wherein the second wiring structure includes a third wiring pattern connected to the second metal-oxide semiconductor film.

9. The semiconductor memory device of claim 8, further comprising a third wiring structure stacked on the second wiring structure,
wherein the third wiring structure includes a fourth wiring pattern connected to the first gate electrode and a fifth wiring pattern connected to the second gate electrode.

10. The semiconductor memory device of any one of claims 1 to 9, wherein each of the first metal-oxide semiconductor film and the second metal-oxide semiconductor film includes indium gallium zinc oxide (IGZO).

11. The semiconductor memory device of any one of claims 1 to 10, wherein the charge storage film includes at least one of polysilicon or silicon nitride.

12. A semiconductor memory device comprising:
a substrate;
a circuit element on the substrate;
a lower insulating film on the substrate, the lower insulating film covering the circuit element;
a first wiring structure on the lower insulating film, the first wiring structure including a first wiring pattern and a second wiring pattern spaced apart from each other;
a first metal-oxide semiconductor film on the first wiring structure, the first metal-oxide semiconductor film connected to the first wiring pattern and the second wiring pattern;
a second metal-oxide semiconductor film on the first wiring structure, the second metal-oxide semiconductor film spaced apart from the first metal-oxide semiconductor film;
a first gate electrode intersecting the first metal-oxide semiconductor film and the second metal-oxide semiconductor film;
a charge storage film between the first metal-oxide semiconductor film and the first gate electrode, the charge storage film connected to the second metal-oxide semiconductor film;
a second gate electrode intersecting the second metal-oxide semiconductor film and not intersecting the first metal-oxide semiconductor film;
a second wiring structure on the first gate electrode and the second gate electrode, the second wiring structure including a third wiring pattern connected to the second metal-oxide semiconductor film; and
a third wiring structure on the second wiring structure, the third wiring structure including a fourth wiring pattern connected to the first gate electrode and a fifth wiring pattern connected to the second gate electrode.

13. The semiconductor memory device of claim 12, wherein each of the first metal-oxide semiconductor film and the second metal-oxide semiconductor film extends in a first direction parallel to an upper surface of the substrate, and
each of the first gate electrode and the second gate electrode extends in a second direction intersecting the upper surface of the substrate.

14. The semiconductor memory device of claim 13, wherein the first metal-oxide semiconductor film extends in the first direction and penetrates through the first gate electrode, and
the second metal-oxide semiconductor film extends in the first direction and penetrates through the first gate electrode and the second gate electrode.

15. The semiconductor memory device of claim 13 or 14, wherein the first metal-oxide semiconductor film and the second metal-oxide semiconductor film are spaced apart from each other in the second direction, and
the first gate electrode and the second gate electrode are spaced apart from each other in the first direction.
